# EUROPEAN PATENT SPECIFICATION

(11) **EP 4 047 808 B1**
(45) Date of publication and mention of the grant of the patent: **19.02.2025**
(21) Application number: 20877012.3
(22) Date of filing: 29.09.2020
(51) Int. Cl.: H02N 2/18, H10N 30/30

(54) **POWER GENERATION DEVICE AND INPUT DEVICE**
LEISTUNGSERZEUGUNGSVORRICHTUNG UND EINGABEVORRICHTUNG
DISPOSITIF DE GÉNÉRATION DE PUISSANCE ET DISPOSITIF D'ENTRÉE

(30) Priority: 15.10.2019 JP 2019188996
(43) Date of publication of application: 24.08.2022
(73) Proprietor: Panasonic Intellectual Property Management Co., Ltd., Osaka-shi, Osaka 540-6207 (JP)
(72) Inventor: NODA, Masaaki, Osaka-shi, Osaka 540-6207 (JP)
(74) Representative: Vigand, Philippe
(86) International application number: PCT/JP2020/036796
(87) International publication number: WO 2021/075252

(56) References cited:
- CN-A- 102 661 424
- CN-A- 103 036 478
- CN-A- 107 317 516
- CN-A- 107 317 516
- CN-A- 107 565 948
- CN-A- 107 565 948
- CN-U- 202 524 324
- CN-U- 204 376 762
- CN-U- 207 588 735
- JP-A- 2014 030 326
- JP-A- 2015 097 453
- JP-A- 2018 203 204
- JP-A- H11 136 931
- US-A1- 2016 013 737

## Description

### TECHNICAL FIELD

The present disclosure relates to power generation devices and input devices and more specifically relates to a power generation device that generates electric power using vibration and to an input device including the power generation device.

### BACKGROUND ART

Patent Literature (PTL) 1 discloses a power generation device. This power generation device includes a start-up unit and a power generation unit. The start-up unit includes an attraction body. The attraction body moves from a start point toward an end point. The power generation unit has a cantilever shape. The power generation unit vibrates and thereby generates electric power.

The attraction body attracts the power generation unit when the attraction body is moving from the start point to the end point. The power generation unit deflects due to the movement of the attraction body toward the end point while the power generation unit is attracted to the attraction body. When the attraction body moves further toward the end point, the attraction body separates from the power generation unit midway through the movement. This separation of the attraction body causes the power generation unit to start vibrating. The document CN107317516 A discloses a self-powered ship-borne positioning and tracking device, the document CN107565948 A discloses a self-powered piezoelectric switch, the document CN204376762 U discloses a new concept of a piezoelectric generator, the document CN102661424 A discloses a plunger piston type piezoelectric valve based on multi-vibrator tandem drive.

### Citation List

### Patent Literature

PTL 1: International Publication No. 2018-100859

### SUMMARY OF THE INVENTION

The present invention is directed to an input device according to independent device claim 1 and to a power generating device according to independent device claim 12.

### BRIEF DESCRIPTION OF THE DRAWINGS

Fig. 1 is a cross-sectional view of a power generation device according to Embodiment 1, illustrating the state in which a movable element is in the first position;
Fig. 2 is a cross-sectional view of the power generation device, illustrating the state in which a movable element is in the second position;
Fig. 3 is a diagram for describing the operation of the power generation device;
Fig. 4 is a diagram for describing the operation of the power generation device;
Fig. 5 is a diagram for describing the operation of the power generation device;
Fig. 6 is a diagram for describing the operation of the power generation device;
Fig. 7 is a block diagram of an input device including the power generation device;
Fig. 8 is a cross-sectional view of a power generation device according to Embodiment 2, illustrating the state in which a movable element is in the first position;
Fig. 9 is a diagram for describing a magnetic path in the power generation device in the state in which the movable element is in the first position;
Fig. 10 is a cross-sectional view of the power generation device, illustrating the state in which the movable element is in the second position;
Fig. 11 is a diagram for describing a magnetic path in the power generation device in the state in which the movable element is in the second position;
Fig. 12 is a cross-sectional view of a power generation device according to Embodiment 3;
Fig. 13 is a diagram for describing a magnetic path in the power generation device in the state in which the movable element is in the first position;
Fig. 14 is a diagram for describing a magnetic path in the power generation device in the state in which the movable element is in the second position;
Fig. 15 is a cross-sectional view of a power generation device according to Embodiment 4, illustrating the state in which a movable element is in the first position;
Fig. 16 is a cross-sectional view of the power generation device, illustrating the state in which the movable element is in the second position;
Fig. 17 is a block diagram of an input device including the power generation device in the first example; and
Fig. 18 is a block diagram of an input device including the power generation device in the second example.

### DESCRIPTION OF EMBODIMENTS

Hereinafter, power generation devices and input devices according to exemplary embodiments of the present disclosure will be described with reference to the attached drawings. Note that each of the following exemplary embodiments is merely a part of various exemplary embodiments of the present disclosure. Various changes can be made to each of the following exemplary embodiments according to the design or the like as long as the object of the present disclosure can be achieved. Furthermore, each figure described in the following exemplary embodiments is a schematic diagram, meaning that the ratio between the sizes of structural elements in each figure and the ratio between the thicknesses of structural elements in each figure do not necessarily reflect an actual dimension ratio.

### (1) Embodiment 1

### (1. 1) Power Generation Device

### (1. 1. 1) Outline

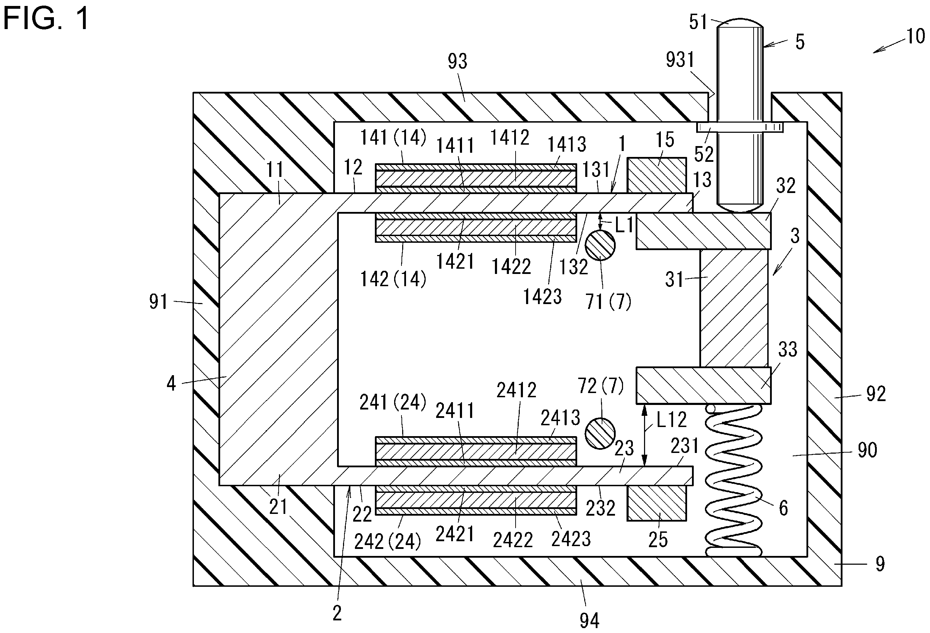

As illustrated in Fig. 1, power generation device 10 according to the present exemplary embodiment includes first piezoelectric vibrating power generation element 1 (which may also be hereinafter simply referred to as "first element 1"); second piezoelectric vibrating power generation element 2 (which may also be hereinafter simply referred to as "second element 2"); and movable element 3.

First element 1 generates first electric power by vibration, and second element 2 generates second electric power by vibration. In other words, first element 1 and second element 2 separately generate electric power by vibration. Each of first element 1 and second element 2 is in the form of a cantilever having a fixed end and a free end.

Movable element 3 is formed of a magnetic material. Movable element 3 herein includes permanent magnet 31. Movable element 3 attracts each of first element 1 and second element 2 by a magnetic force.

Movable element 3 can move between the first position and the second position.

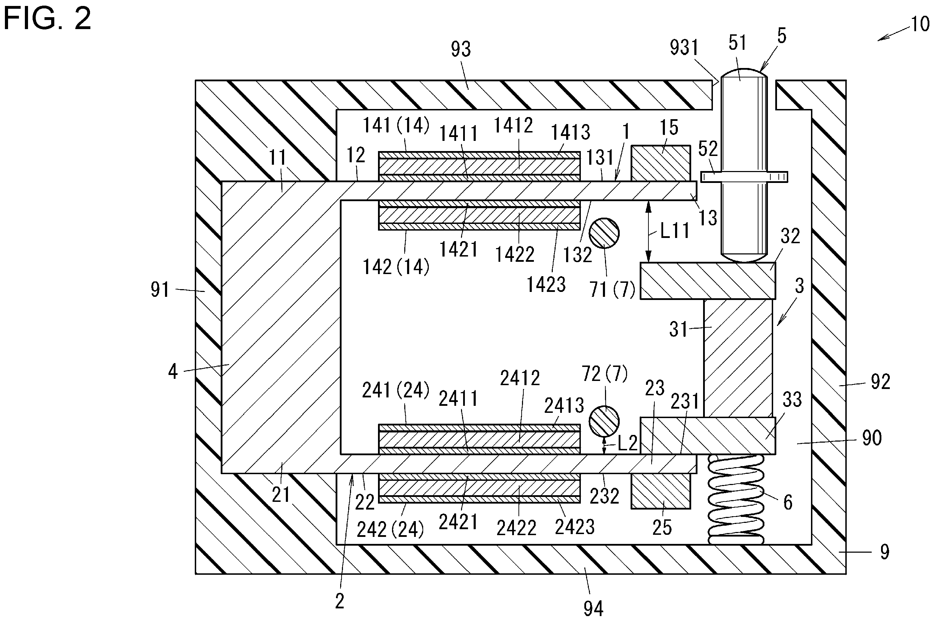

Here, the first position of movable element 3 is the position of movable element 3 in contact with first element 1 (refer to Fig. 1). In the first position, movable element 3 is in contact with the first end (free end) of first element 1. The second position of movable element 3 is the position of movable element 3 in contact with second element 2 (refer to Fig. 2). In the second position, movable element 3 is in contact with the first end (free end) of second element 2.

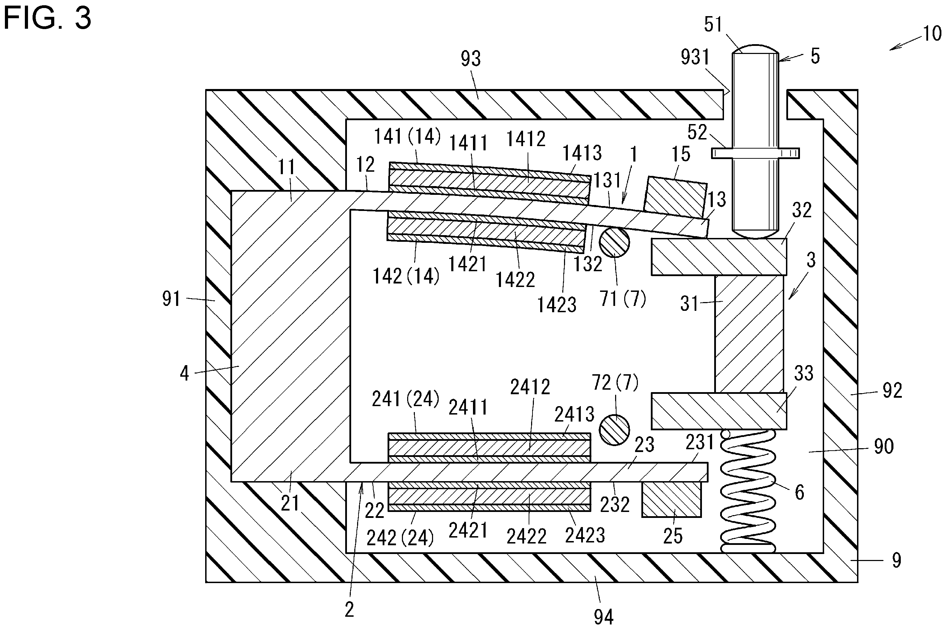

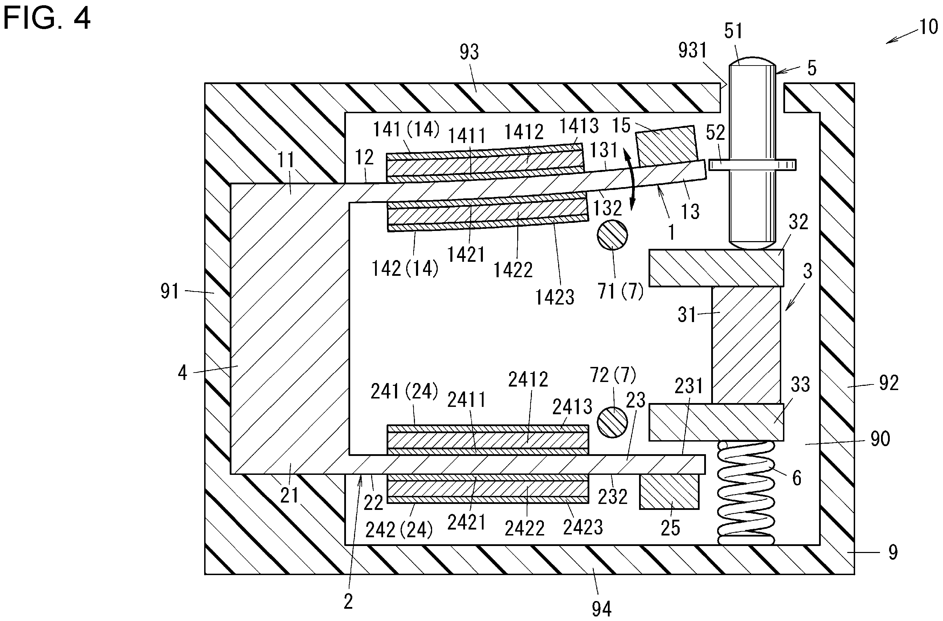

When movable element 3 in the first position (refer to Fig. 1) moves toward the second position, first element 1 is curved with the first end (free end) attracted to movable element 3 by the magnetic force (refer to Fig. 3). Subsequently, when movable element 3 moves further toward the second position and separates from first element 1, first element 1 starts vibrating (refer to Fig. 4). In other words, when movable element 3 is moving from the first position to the second position, movable element 3 causes one of first element 1 and second element 2 (in this example, first element 1) to start vibrating. First element 1 vibrates and thereby generates electric power.

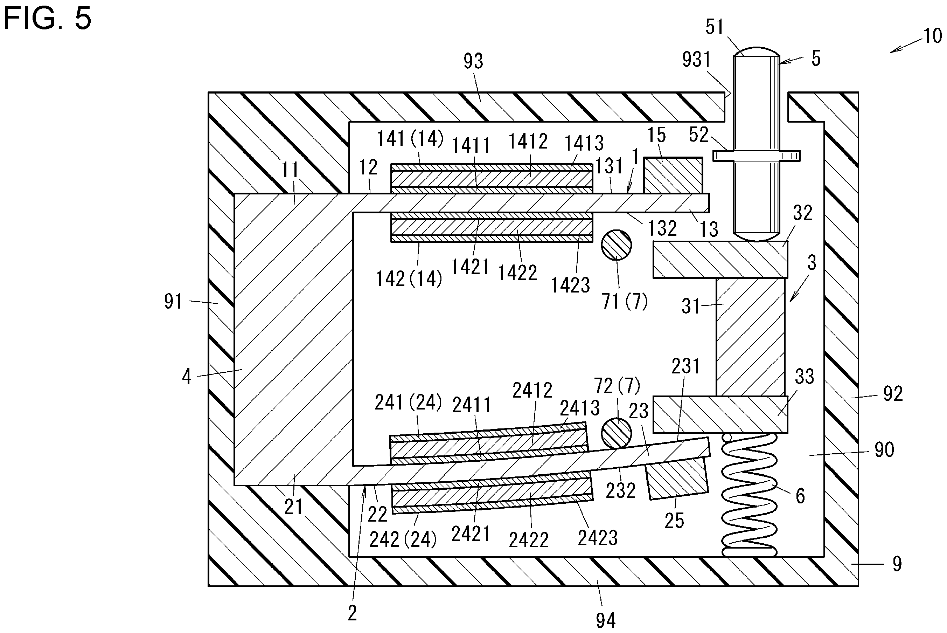

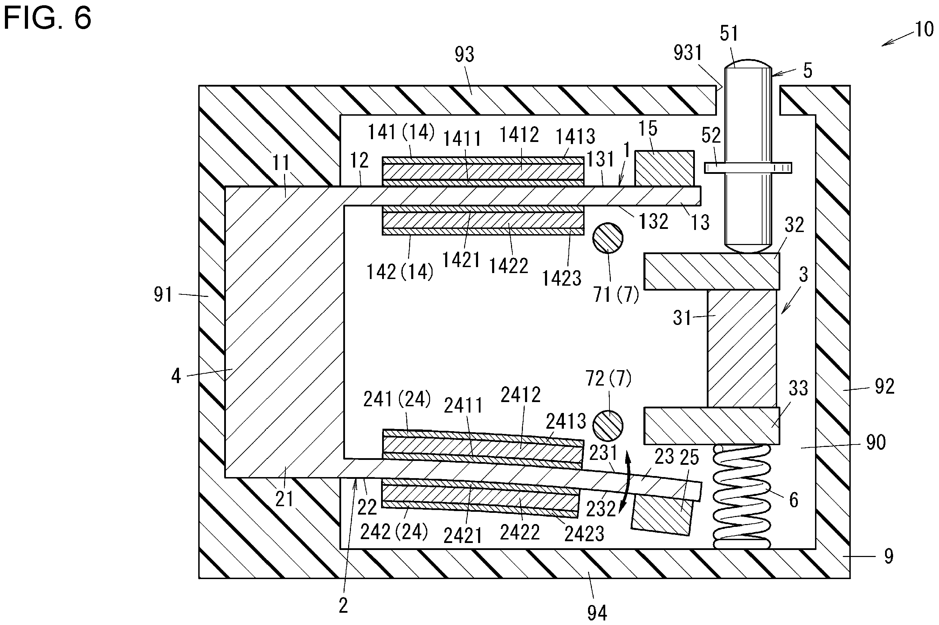

When movable element 3 in the second position (refer to Fig. 2) moves toward the first position, second element 2 is curved with the first end (free end) attracted to movable element 3 by the magnetic force (refer to Fig. 5). Subsequently, when movable element 3 moves further toward the first position and separates from second element 2, second element 2 starts vibrating (refer to Fig. 6). In other words, when movable element 3 is moving from the second position to the first position, movable element 3 causes one of first element 1 and second element 2 (in this example, second element 2) to start vibrating. Second element 2 vibrates and thereby generates electric power.

In power generation device 10 according to the present exemplary embodiment, both when movable element 3 moves from the first position to the second position and when movable element 3 moves from the second position to the first position, electric power can be generated. Thus, with power generation device 10 according to the present exemplary embodiment, it is possible to improve power generation efficiency.

### (1. 1. 2) Configuration

Power generation device 10 according to the present exemplary embodiment will be described in more detail with reference to Figs. 1 to 6.

As illustrated in Fig. 1, power generation device 10 includes support body 4, push button 5, return portion 6, stopper 7, and housing 9 in addition to first element 1, second element 2, and movable element 3.

As mentioned earlier, movable element 3 can move between the first position and the second position. Here, movable element 3 can move between the first position and the second position along one line. In the following description, a direction in which movable element 3 can move (the vertical direction in Fig. 1) will also be referred to as the "vertical direction". An orientation in which movable element 3 moves from the first position to the second position (the downward direction in Fig. 1) will also be referred to as "down", and an orientation in which movable element 3 moves from the second position to the first position (the upward direction in Fig. 1) will also be referred to as "up". Note that in the present disclosure, although description is made using terms indicating directions such as "up", "down", "right", "left", "above", and "below", these merely indicate relative positioning and do not limit the present disclosure.

Each of first element 1 and second element 2 is elongated and extends in a direction orthogonal to the vertical direction. The direction of extension of each of first element 1 and second element 2 (the horizontal direction in Fig. 1) will also be referred to as the "horizontal direction" in the following description. Furthermore, each of first element 1 and second element 2 is supported on support body 4, at one end of the element in the direction of extension thereof. In the following description, an area on the side on which one end (the left end in Fig. 1) of each of first element 1 and second element 2 supported on support body 4 is located will also be referred to as "left", and an area on the opposite side will also be referred to as "right".

Furthermore, in the following direction, a direction orthogonal to both the vertical direction and the horizontal direction (a direction perpendicular to the drawing sheet of Fig. 1) will also be referred to as the "depth direction", the front of the drawing sheet of Fig. 1 will also be referred to as "front", and the back of the drawing sheet of Fig. 1 will also be referred to as "back".

Note that directions such as "up", "down", "front", "back", "left", and "right" in the present disclosure are defined for the sake of explanation and do not limit, for example, the directions of power generation device 10 when in use.

As illustrated in Fig. 1, housing 9 is in the shape of a rectangular box having left wall 91, right wall 92, upper wall 93, lower wall 94, a front wall, and a back wall. Housing 9 is formed of a non-magnetic material such as resin. Housing 9 includes internal space 90. Internal space 90 herein is enclosed except for hole 931 formed in upper wall 93. However, this is not limiting; internal space 90 of housing 9 may be connected to the space external to housing 9 through a hole or the like formed in a wall of housing 9.

First element 1, second element 2, movable element 3, a portion (lower portion) of push button 5, return portion 6, and stopper 7 are housed in internal space of housing 9. Support body 4 is embedded in left wall 91 of housing 9 and thus held on housing 9.

As illustrated in Fig. 1, first element 1 includes support portion (first support portion) 11 and vibration portion (first vibration portion) 12.

Support portion 11 is a portion of first element 1 that is supported on support body 4. Support portion 11 is the left-hand portion of first element 1. Support portion 11 is formed of a soft magnetic material. Support portion 11 herein is made of magnetic stainless steel (SUS).

Vibration portion 12 is elongated horizontally. Vibration portion 12 extends rightward from the right end of support portion 11. Vibration portion 12 is supported on support portion 11 in such a manner as to be able to vibrate (swing). One longitudinal end (the left end) of vibration portion 12 is a fixed end that is fixed to support portion 11, and the other longitudinal end (the right end) of vibration portion 12 is a free end. In other words, first element 1 has a cantilever structure.

Vibration portion 12 includes beam (first beam) 13, power generator (first power generator) 14, and weight (first weight) 15.

Beam 13 is formed of a soft magnetic material. Beam 13 herein is made of magnetic stainless steel (SUS). Beam 13 is integrally formed with support portion 11.

Beam 13 is in the form of a horizontally elongated rectangular board. The thickness axis of beam 13 extends vertically. Beam 13 has first surface 131 in one direction (on the upper side) and second surface 132 in the other direction (on the lower side) along the thickness of beam 13.

Beam 13 is flexible. Beam 13 is capable of vibrating vertically with the portion (fixed end) supported on support portion 11 as a fulcrum.

Power generator (first power generator) 14 generates electric power according to the vibration of beam 13. Power generator 14 includes first piezoelectric converter 141 and second piezoelectric converter 142. First piezoelectric converter 141 is provided on first surface (upper surface) 131 of beam 13. Second piezoelectric converter 142 is provided on second surface (lower surface) 132 of beam 13.

First piezoelectric converter 141 includes first electrode (lower electrode) 1411 stacked on first surface 131 of beam 13; piezoelectric body 1412 stacked on first electrode 1411; and second electrode (upper electrode) 1413 stacked on piezoelectric body 1412. In other words, first piezoelectric converter 141 includes a stacked structure of first electrode 1411, piezoelectric body 1412, and second electrode 1413 disposed on first surface 131 of beam 13.

The material of first electrode 1411 and the material of second electrode 1413 are Pt, for example. However, this is not limiting; the material of first electrode 1411 and the material of second electrode 1413 may be Au, Al, Ir, or the like, for example. The material of first electrode 1411 and the material of second electrode 1413 may be the same or different.

Piezoelectric body 1412 herein is piezoelectric ceramics. The material of piezoelectric body 1412 is PZT (Pb(Zr, Ti)O₃), for example. However, this is not limiting; the material of piezoelectric body 1412 may be PZT-PMN(Pb(Mn, Nb)O₃), PZT with impurities added thereto, or the like, for example. Furthermore, the material of piezoelectric body 1412 may be AlN, ZnO, KNN(K_{0.5}Na_{0.5}NbO₃), KN(KNbO₃), NN(NaNbO₃), KNN with impurities added thereto, or the like. Examples of the impurities include Li, Nb, Ta, Sb, and Cu.

Second piezoelectric converter 142 includes first electrode (upper electrode) 1421 stacked on second surface 132 of beam 13; piezoelectric body 1422 stacked on first electrode 1421; and second electrode (lower electrode) 1423 stacked on piezoelectric body 1422. In other words, second piezoelectric converter 142 includes a stacked structure of first electrode 1421, piezoelectric body 1422, and second electrode 1423 disposed on second surface 132 of beam 13.

As the materials of first electrode 1421 and second electrode 1423, the materials cited as examples of the material of first electrode 1411 and second electrode 1413 can be used, for example. As the material of piezoelectric body 1422, the materials cited as examples of the material of piezoelectric body 1412 can be used.

In first element 1, when vibration portion 12 vibrates, piezoelectric body 1412 of first piezoelectric converter 141 receives stress. Thus, in first element 1, electric charge in first electrode 1411 and second electrode 1413 of first piezoelectric converter 141 becomes uneven, and an alternating voltage is generated in first piezoelectric converter 141. Furthermore, in first element 1, when vibration portion 12 vibrates, piezoelectric body 1422 of second piezoelectric converter 142 receives stress. Thus, in first element 1, electric charge in first electrode 1421 and second electrode 1423 of second piezoelectric converter 142 becomes uneven, and an alternating voltage is generated in second piezoelectric converter 142.

In other words, first element 1 is a vibrating power generation element that generates electric power using the piezoelectric effect of a piezoelectric material.

Weight 15 is provided on first surface 131 of beam 13. Weight 15 is provided in order to adjust the resonance frequency of vibration portion 12. The material of weight 15 is not particularly limited and may be metal or non-metal. Weight 15 can be omitted.

The alternating voltage generated in first piezoelectric converter 141 and the alternating voltage generated in second piezoelectric converter 142 are alternating voltages in the form of sine waves corresponding to the vibration of piezoelectric bodies 1412, 1422. The resonance frequency of vibration portion 12 depends on the structure parameter and the material of each of beam 13, power generator 14, and weight 15.

As illustrated in Fig. 1, second element 2 includes support portion (second support portion) 21 and vibration portion (second vibration portion) 22. Here, second element 2 is shaped as a reflection of first element 1.

Support portion 21 is a portion of second element 2 that is supported on support body 4. Support portion 21 is the left-hand portion of second element 2. Support portion 21 is located opposite support portion 11 with support body 4 disposed therebetween. Support portion 21 is formed of a soft magnetic material. Support portion 21 herein is made of magnetic stainless steel (SUS).

Vibration portion 22 is elongated horizontally. Vibration portion 22 extends rightward from the right end of support portion 21. Vibration portion 22 is supported on support portion 21 in such a manner as to be able to vibrate (swing). One longitudinal end (the left end) of vibration portion 22 is a fixed end that is fixed to support portion 21, and the other longitudinal end (the right end) of vibration portion 22 is a free end. In other words, second element 2 has a cantilever structure.

Vibration portion 22 is disposed so as to face vibration portion 12 in the vertical direction. Here, the longitudinal axis of vibration portion 12 and the longitudinal axis of vibration portion 22 are substantially parallel.

Vibration portion 22 includes beam (second beam) 23, power generator (second power generator) 24, and weight (second weight) 25.

Beam 23 is formed of a soft magnetic material. Beam 23 herein is made of magnetic stainless steel (SUS). Beam 23 is integrally formed with support portion 21.

Beam 23 is in the form of a horizontally elongated rectangular board. The thickness axis of beam 23 extends vertically. Beam 23 has first surface 231 in one direction (on the upper side) and second surface 232 in the other direction (on the lower side) along the thickness of beam 23.

Beam 23 is flexible. Beam 23 is capable of vibrating vertically with the portion (fixed end) supported on support portion 21 as a fulcrum. This means that in power generation device 10 according to the present exemplary embodiment, a direction in which first element 1 vibrates and a direction in which second element 2 vibrates are along the same line.

Power generator (second power generator) 24 generates electric power according to the vibration of beam 23. Power generator 24 includes third piezoelectric converter 241 and fourth piezoelectric converter 242. Third piezoelectric converter 241 is provided on first surface (upper surface) 231 of beam 23. Fourth piezoelectric converter 242 is provided on second surface (lower surface) 232 of beam 23.

Third piezoelectric converter 241 includes first electrode (lower electrode) 2411 stacked on first surface 231 of beam 23; piezoelectric body 2412 stacked on first electrode 2411; and second electrode (upper electrode) 2413 stacked on piezoelectric body 2412. In other words, third piezoelectric converter 241 includes a stacked structure of first electrode 2411, piezoelectric body 2412, and second electrode 2413 disposed on first surface 231 of beam 23.

Four piezoelectric converter 242 includes first electrode (upper electrode) 2421 stacked on second surface 232 of beam 23; piezoelectric body 2422 stacked on first electrode 2421; and second electrode (lower electrode) 2423 stacked on piezoelectric body 2422. In other words, fourth piezoelectric converter 242 includes a stacked structure of first electrode 2421, piezoelectric body 2422, and second electrode 2423 disposed on second surface 232 of beam 23.

As the materials of first electrodes 2411, 2421 and the materials of second electrodes 2413, 2423, the materials cited as examples of the material of first electrode 1411 and the material of second electrode 1413 can be used, for example. As the material of piezoelectric bodies 2412, 2422, the materials cited as examples of the material of piezoelectric body 1412 can be used.

In second element 2, when vibration portion 22 vibrates, piezoelectric body 2412 of third piezoelectric converter 241 receives stress. Thus, in second element 2, electric charge in first electrode 2411 and second electrode 2413 of third piezoelectric converter 241 becomes uneven, and an alternating voltage is generated in third piezoelectric converter 241. Furthermore, in second element 2, when vibration portion 22 vibrates, piezoelectric body 2422 of fourth piezoelectric converter 242 receives stress. Thus, in second element 2, electric charge in first electrode 2421 and second electrode 2423 of fourth piezoelectric converter 242 becomes uneven, and an alternating voltage is generated in fourth piezoelectric converter 242.

In other words, second element 2 is a vibrating power generation element that generates electric power using the piezoelectric effect of a piezoelectric material, as with first element 1.

Weight 25 is provided on second surface 232 of beam 23. Weight 25 is provided in order to adjust the resonance frequency of vibration portion 22. The material of weight 25 is not particularly limited and may be metal or non-metal. Weight 25 can be omitted.

The alternating voltage generated in third piezoelectric converter 241 and the alternating voltage generated in fourth piezoelectric converter 242 are alternating voltages in the form of sine waves corresponding to the vibration of piezoelectric bodies 2412, 2422. The resonance frequency of vibration portion 22 depends on the structure parameter and the material of each of beam 23, power generator 24, and weight 25.

As illustrated in Fig. 1, support body 4 is in the form of a vertically elongated rectangular cuboid. Support body 4 is formed of a soft magnetic material such as soft iron. One end (the upper end) of support body 4 along a longitudinal axis thereof is connected to support portion 11 of first element 1. The other end (the lower end) of support body 4 along the longitudinal axis thereof is connected to support portion 21 of second element 2. In other words, support body 4 connects one end (the left end) of first element 1 and one end (the left end) of second element 2. First element 1, second element 2, and support body 4 form a "C" shape as viewed from the front. Here, support portion 11 of first element 1, support portion 21 of second element 2, and support body 4 are integrally formed. However, support portion 11 of first element 1 and support body 4 may be separate, and support portion 21 of second element 2 and support body 4 may be separate. For example, appropriate bonding means such as screwing and welding may be used to bond support portion 11 of first element 1 and support body 4 together and bond support portion 21 of second element 2 and support body 4 together.

Support body 4 is held on left wall 91 of housing 9. First element 1 and second element 2 protrude from left wall 91 of housing 9.

As illustrated in Fig. 1, movable element 3 includes permanent magnet 31, first magnetic body 32, and second magnetic body 33.

Permanent magnet 31 includes pole faces (a N-pole face and a S-pole face) on vertically opposite surfaces. Here, the upper surface (first surface) of permanent magnet 31 is the N-pole face, and the lower surface (second surface) of permanent magnet 31 is the S-pole face.

First magnetic body 32 is formed of a soft magnetic material. First magnetic body 32 is provided on the first surface of permanent magnet 31. First magnetic body 32 protrudes horizontally (leftward) from above the first surface of permanent magnet 31.

Second magnetic body 33 is formed of a soft magnetic material. Second magnetic body 33 is provided on the second surface of permanent magnet 31. Second magnetic body 33 protrudes horizontally (leftward) from below the second surface of permanent magnet 31.

With permanent magnet 31, first magnetic body 32, and second magnetic body 33, movable element 3 is in the form of an inverted "C" shape as viewed from the front (a "C" shape open in the direction opposite to that formed by first element 1, second element 2, and support body 4).

Movable element 3 is disposed in internal space 90 of housing 9. Movable element 3 can move vertically between the first position and the second position. In internal space 90, movable element 3 moves along right wall 92 of housing 9.

As illustrated in Fig. 1, the first position is the position of movable element 3 in contact with vibration portion 12 of first element 1. In the first position, movable element 3 contacts first element 1 by attracting first element 1 (more specifically, beam 13) by the magnetic force. In the first position, movable element 3 and first element 1 are joined together by the magnetic force. Meanwhile, in the first position, movable element 3 is separate from second element 2.

Note that the first position of movable element 3 is, for example, the position of movable element 3 with first magnetic body 32 in direct contact with second surface 132 of beam 13 as illustrated in Fig. 1, but this is not limiting. For example, when vibration portion 12 includes a magnetic body on second surface 132 of beam 13, the first position of movable element 3 may be the position of movable element 3 with first magnetic body 32 in direct contact with said magnetic body. Furthermore, for example, when movable element 3 does not include first magnetic body 32, the first position of movable element 3 may be the position of movable element 3 with permanent magnet 31 having an upper surface in direct contact with second surface 132 of beam 13.

As illustrated in Fig. 2, the second position is the position of movable element 3 in contact with vibration portion 22 of second element 2. In the second position, movable element 3 contacts second element 2 by attracting second element 2 (more specifically, beam 23) by the magnetic force. In the second position, movable element 3 and second element 2 are joined together by the magnetic force. Meanwhile, in the second position, movable element 3 is separate from first element 1.

Note that the second position of movable element 3 is, for example, the position of movable element 3 with second magnetic body 33 in direct contact with first surface 231 of beam 23 as illustrated in Fig. 2, but this is not limiting. For example, when vibration portion 22 includes a magnetic body on first surface 231 of beam 23, the second position of movable element 3 may be the position of movable element 3 with second magnetic body 33 in direct contact with said magnetic body. Furthermore, for example, when movable element 3 does not include second magnetic body 33, the second position of movable element 3 may be the position of movable element 3 with permanent magnet 31 having a lower surface in direct contact with first surface 231 of beam 23.

Note that a guide rib for restricting vertical movement of movable element 3 may be formed on the inner surfaces of the front and back walls of housing 9, for example.

As illustrated in Fig. 1, push button 5 is disposed on a vertical extension of movable element 3. Push button 5 is disposed in hole 931 vertically penetrating upper wall 93 of housing 9. Push button 5 receives a push operation performed by an operator. According to the push operation, push button 5 causes movable element 3 to move from the first position toward the second position.

As illustrated in Fig. 1, push button 5 includes operation body 51 and flange portion 52.

Operation body 51 is in the shape of a vertically elongated cylinder. Operation body 51 is disposed so as to extend through hole 931, the upper end of operation body 51 protrudes upward from upper wall 93 of housing 9, and the lower end of operation body 51 faces the upper surface of movable element 3 in internal space 90 of housing 9. Without push button 5 having been operated, the lower end of operation body 51 is in contact with the upper surface of movable element 3, but this is not limiting; the lower end of operation body 51 may be separate from the upper surface of movable element 3.

When an operator presses the upper end of operation body 51, push button 5 moves downward. At this time, the lower end of operation body 51 pushes the upper surface of movable element 3, and thus movable element 3 moves downward. This means that when an operator presses push button 5, movable element 3 moves from the first position toward the second position.

Flange portion 52 is formed in the shape of a disc protruding outward in the radius direction of operation body 51, in the middle of the longitudinal length of operation body 51. Flange portion 52 is provided on the outer surface of operation body 51 so as to be included in internal space 90. With the upper surface contacting the lower surface of upper wall 93 of housing 9, flange portion 52 prevents push button 5 from moving further upward.

Return portion 6 provides, to movable element 3, a force acting in the direction from the second direction to the first direction. Return portion 6 herein is a coil spring. The coil spring is disposed between lower wall 94 of housing 9 and the lower surface of movable element3 so that the axis of the coil spring extends vertically.

When push button 5 receives the push operation performed by an operator, the coil spring constituting return portion 6 is compressed under the press force via movable element 3 (refer to Fig. 2). Subsequently, when the operator takes his or her hand off push button 5 to end the push operation, the coil spring pushes movable element 3 and push button 5 upward by the elastic force of the coil spring, causing movable element 3 to move toward the first position.

Stopper 7 includes first stopper 71 and second stopper 72.

First stopper 71 is in the shape of a rod extending in the depth direction. First stopper 71 is disposed near the free end of vibration portion 12 of first element 1 in internal space 90 of housing 9. First stopper 71 is disposed on the same side as movable element 3 as viewed from first element 1; in other words, first stopper 71 is disposed below first element 1. First stopper 71 is disposed between first element 1 and second element 2. When beam 13 of first element 1 is curved downward, first stopper 71 contacts second surface 132 of beam 13, preventing beam 13 from being curved more (refer to Fig. 3).

As illustrated in Fig. 1, when movable element 3 is in the first position, distance L1 between first stopper 71 and first element 1 is less than distance L12 between movable element 3 and second element 2. Therefore, when movable element 3 is moving from the first position to the second position, first element 1 curved according to the movement of movable element 3 contacts first stopper 71 before movable element 3 contacts second element 2 (refer to Fig. 3). In other words, when movable element 3 is moving from the first position to the second position, movable element 3 separates from first element 1 and then contacts second element 2.

In other words, power generation device 10 includes first stopper 71. When movable element 3 is moving from the first position to the second position, first stopper 71 causes first element 1 to separate from movable element 3 before movable element 3 contacts second element 2. Here, first stopper 71 contacts first element 1, causing first element 1 to separate from movable element 3.

Note that when movable element 3 is moving from the first position to the second position, the magnetic force between movable element 3 and second element 2 increases, and second element 2 may be curved upward. First stopper 71 is preferably disposed in such a position as to cause first element 1 to separate from movable element 3 before movable element 3 contacts second element 2 even when second element 2 is curved by the magnetic force.

Second stopper 72 is in the shape of a rod extending in the depth direction. Second stopper 72 is disposed near the free end of vibration portion 22 of second element 2 in internal space 90 of housing 9. Second stopper 72 is disposed on the same side as movable element 3 as viewed from second element 2; in other words, second stopper 72 is disposed above second element 2. Second stopper 72 is disposed between first element 1 and second element 2. When beam 23 of second element 2 is curved upward, second stopper 72 contacts first surface 231 of beam 23, preventing beam 23 from being curved more.

As illustrated in Fig. 2, when movable element 3 is in the second position, distance L2 between second stopper 72 and second element 2 is less than distance L11 between movable element 3 and first element 1. Therefore, when movable element 3 is moving from the second position to the first position, second element 2 curved according to the movement of movable element 3 contacts second stopper 72 before movable element 3 contacts first element 1 (refer to Fig. 5). In other words, when movable element 3 is moving from the second position to the first position, movable element 3 separates from second element 2 and then contacts first element 1.

In other words, power generation device 10 includes second stopper 72. When movable element 3 is moving from the second position to the first position, second stopper 72 causes second element 2 to separate from movable element 3 before movable element 3 contacts first element 1. Here, second stopper 72 contacts second element 2, causing second element 2 to separate from movable element 3.

Note that when movable element 3 is moving from the second position to the first position, the magnetic force between movable element 3 and first element 1 increases, and first element 1 may be curved downward. Second stopper 72 is preferably disposed in such a position as to cause second element 2 to separate from movable element 3 before movable element 3 contacts first element 1 even when first element 1 is curved by the magnetic force.

### (1. 1. 3) Operation

Next, the operation of power generation device 10 will be described with reference to Figs. 1 to 6.

When an operator is not performing the push operation on push button 5, movable element 3 is located at the first position under the upward force provided by return portion 6 (refer to Fig. 1). At this time, the free end of vibration portion 12 of first element 1 is attracted and attached to the upper surface of movable element 3 (the upper surface of first magnetic body 32) by the magnetic force (force of attraction) between the free end and movable element 3. Second element 2 is subject to the magnetic force (force of attraction) between second element 2 and movable element 3, but stays stationary away from the lower surface of movable element 3 by balancing with, for example, stress on beam 23.

When an operator performs the push operation on push button 5, operation body 51 of push button 5 moves downward. Movable element 3 is pushed by operation body 51 and thus moves downward while compressing the coil spring constituting return portion 6. At this time, the free end of vibration portion 12 of first element 1 attracted and attached to movable element 3 moves downward together with movable element 3, and beam 13 is curved.

When movable element 3 moves downward until lower surface 132 of beam 13 contacts first stopper 71 (refer to Fig. 3), first stopper 71 prevents the free end of vibration portion 12 from moving further downward. When the force (downward force) pushing push button 5 exceeds a force required to cancel magnetic attraction between movable element 3 and first element 1, movable element 3 separates from first element 1 and moves further downward. When vibration portion 12 of first element 1 separates from movable element 3, vibration portion 12 of first element 1 starts vibrating with an amplitude corresponding to the extent of the curve of beam 13 (refer to Fig. 4). When vibration portion 12 vibrates, power generator 14 generates electric power.

When push button 5 is pressed more, movable element 3 moves further downward, and when movable element 3 reaches the second position, the free end of vibration portion 22 is attracted and attached to the lower surface of movable element 3 (the lower surface of second magnetic body 33) by the magnetic force between vibration portion 22 of second element 2 and movable element 3 (refer to Fig. 2).

When the operator takes his or her hand off push button 5 and ends the push operation, movable element 3 moves upward under the spring force of the coil spring constituting return portion 6. At this time, the free end of vibration portion 22 of second element 2 attracted and attached to movable element 3 moves upward together with movable element 3, and beam 23 is curved.

When movable element 3 moves upward until upper surface 231 of beam 23 contacts second stopper 72 (refer to Fig. 5), second stopper 72 prevents the free end of vibration portion 22 from moving further upward. Movable element 3 separates from second element 2 by the spring force from return portion 6 and moves further upward. When vibration portion 22 of second element 2 separates from movable element 3, vibration portion 22 of second element 2 starts vibrating with an amplitude corresponding to the extent of the curve of beam 23 (refer to Fig. 6). When vibration portion 22 vibrates, power generator 24 generates electric power.

After separating from second element 2, movable element 3 and push button 5 move further upward by the spring force from return portion 6. Subsequently, movable element 3 and push button 5 stop in positions where flange portion 52 of push button 5 contacts the lower surface of upper wall 93 of housing 9 (the first position of movable element 3). At this time, the upper surface of movable element 3 is attracted and attached to first element 1.

In this manner, with power generation device 10, when an operator performs the push operation on push button 5, first element 1 generates electric power. Furthermore, in power generation device 10, when the operator ends the push operation on push button 5 (when the operator takes his or hand off push button 5), second element 2 generates electric power. This means that in power generation device 10 according to the present exemplary embodiment, both when movable element 3 moves from the first position to the second position and when movable element 3 moves from the second position to the first position, electric power can be generated. Thus, with power generation device 10 according to the present exemplary embodiment, it is possible to improve power generation efficiency.

### (1. 2) Input Device

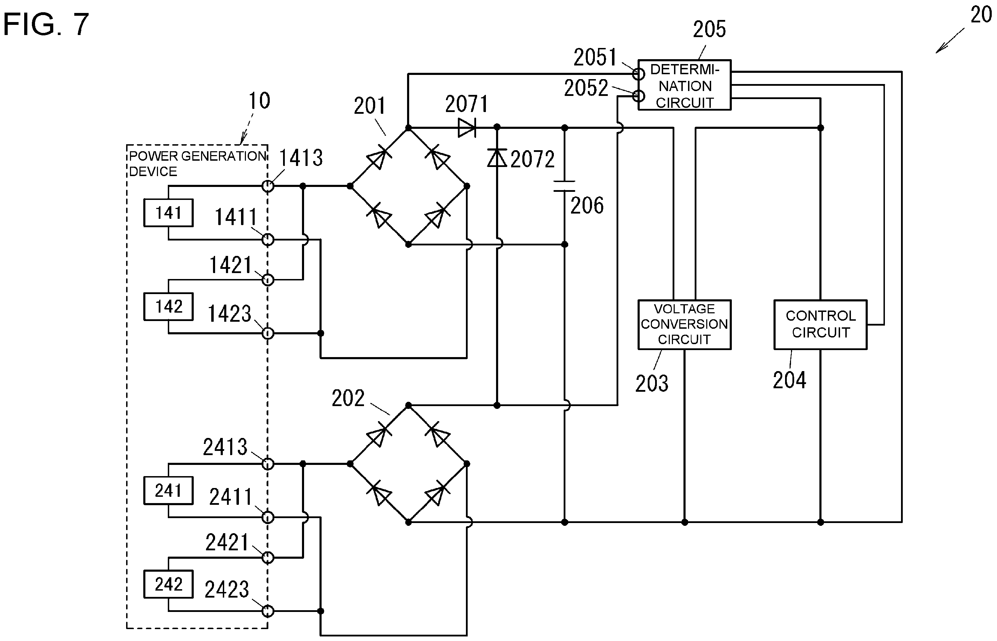

Next, input device 20 including power generation device 10 will be described with reference to Fig. 7.

As illustrated in Fig. 7, input device 20 includes control circuit 204. Control circuit 204 operates using the electric power generated at power generation device 10 and performs a predetermined function. Control circuit 204 includes a radio communication circuit, for example. Control circuit 204 operates using the electric power generated by power generation device 10 when push button 5 is pressed, and performs a function of transmitting, to an external unit, a communication signal indicating that push button 5 has been pressed. It goes without saying that the functions of control circuit are not limited to this function. Control circuit 204 may perform a function of turning on a light source provided on input device 20, may perform a function of causing a sound production device provided on input device 20 to produce sound, and may perform a function of operating a sensor provided on input device 20, for example.

Input device 20 includes first rectifier circuit 201, second rectifier circuit 202, voltage conversion circuit 203, determination circuit 205, power storage element 206, first rectifier 2071, and second rectifier 2072 in addition to power generation device 10 and control circuit 204.

First rectifier circuit 201 adjusts the electric current supplied from first power generator 14 of first element 1 so that the electric current flows in one direction. First rectifier circuit 201 is a what is called a diode bridge in which four didoes are connected in series-parallel.

One input terminal among two input terminals of first rectifier circuit 201 is connected to second electrode (upper electrode) 1413 of first piezoelectric converter 141 and first electrode (upper electrode) 1421 of second piezoelectric converter 142. The other input terminal among the two input terminals of first rectifier circuit 201 is connected to first electrode (lower electrode) 1411 of first piezoelectric converter 141 and second electrode (lower electrode) 1423 of second piezoelectric converter 142.

First rectifier circuit 201 converts, into a pulsating current, the electric current in the form of sine waves generated at power generator 14.

Note that the direction of polarization of piezoelectric body 1412 of first piezoelectric converter 141 and the direction of polarization of piezoelectric body 1422 of second piezoelectric converter 142 are set so that the electrodes connected to the same input terminal among the two input terminals of first rectifier circuit 201 have the same polarity.

Power storage element (capacitor) 206 is connected between two output terminals of first rectifier circuit 201. A diode as first rectifier 2071 is disposed between power storage element 206 and one output terminal (higher-potential output terminal) among the two output terminals of first rectifier circuit 201. Furthermore, one output terminal (higher-potential output terminal) among the two output terminals of first rectifier circuit 201 is connected to first input terminal 2051 of determination circuit 205.

Second rectifier circuit 202 adjusts the electric current supplied from second power generator 24 of second element 2 so that the electric current flows in one direction. Second rectifier circuit 202 is a what is called a diode bridge in which four didoes are connected in series-parallel.

One input terminal among two input terminals of second rectifier circuit 202 is connected to first electrode (upper electrode) 2413 of third piezoelectric converter 241 and first electrode (upper electrode) 2421 of fourth piezoelectric converter 242. The other input terminal among the two input terminals of second rectifier circuit 202 is connected to first electrode (lower electrode) 2411 of third piezoelectric converter 241 and second electrode (lower electrode) 2423 of fourth piezoelectric converter 242.

Second rectifier circuit 202 converts, into a pulsating current, the electric current in the form of sine waves generated at power generator 24.

Note that the direction of polarization of piezoelectric body 2412 of third piezoelectric converter 241 and the direction of polarization of piezoelectric body 2422 of fourth piezoelectric converter 242 are set so that the electrodes connected to the same input terminal among the two input terminals of second rectifier circuit 202 have the same polarity.

Power storage element 206 is connected between two output terminals of second rectifier circuit 202. A diode as second rectifier 2072 is disposed between power storage element 206 and one output terminal (higher-potential output terminal) among the two output terminals of second rectifier circuit 202. Furthermore, one output terminal (higher-potential output terminal) among the two output terminals of second rectifier circuit 202 is connected to second input terminal 2052 of determination circuit 205.

As described above, first rectifier 2071 is disposed between power storage element 206 and one output terminal (higher-potential output terminal) of first rectifier circuit 201. Second rectifier 2072 is disposed between power storage element 206 and one output terminal (higher-potential output terminal) of second rectifier circuit 202. First rectifier 2071 prevents the electric current flowing from second rectifier circuit 202 from flowing into first rectifier circuit 201. Second rectifier 2072 prevents the electric current flowing from first rectifier circuit 201 from flowing into second rectifier circuit 202.

Both ends of power storage element 206 are connected to voltage conversion circuit 203, and voltage conversion circuit 203 is connected to control circuit 204.

Voltage conversion circuit 203 generates an operating voltage for control circuit 204 from electric charge stored in power storage element 206. Voltage conversion circuit 203 is a DC/DC converter, for example. However, this is not limiting; voltage conversion circuit 203 may be a three-terminal regulator, for example. This means that voltage conversion circuit 203 generates the operating voltage using the electric power generated at first element 1 and the electric power generated at second element 2, and supplies the generated operating voltage to control circuit 204.

Control circuit 204 operates at the operating voltage supplied from voltage conversion circuit 203, and performs a desired function. Control circuit 204 includes a computer system including one or more processors (microprocessors) and one or more memories, for example. Specifically, control circuit 204 performs a function by one or more processors performing one or more programs (applications) stored in one or more memories. The programs herein have been recorded on the memories of control circuit 204 in advance, but the programs may be provided through electric communication lines such as the Internet or may be recorded on non-transitory recording media such as memory cards to be provided.

When power generation device 10 generates electric power, determination circuit 205 determines which of first element 1 and second element 2 has generated the electric power. Determination circuit 205 includes a comparator, for example. Determination circuit 205 includes first input terminal 2051 and second input terminal 2052, for example. First input terminal 2051 is connected to the output terminal (higher-potential output terminal) of first rectifier circuit 201. Second input terminal 2052 is connected to the output terminal (higher-potential output terminal) of second rectifier circuit 202. Determination circuit 205 performs the aforementioned determination by comparing the value of a voltage at first input terminal 2051 and the value of a voltage at second input terminal 2052, for example. When the voltage at first input terminal 2051 is greater than the voltage at second input terminal 2052, determination circuit 205 determines that first element 1 has generated the electric power. When the voltage at second input terminal 2052 is greater than the voltage at first input terminal 2051, determination circuit 205 determines that second element 2 has generated the electric power. Determination circuit 205 reports the determination result to control circuit 204.

As already described, first element 1 generates electric power when push button 5 is pressed. Second element 2 generates electric power when push button 5 is released. In other words, because it is possible to identify which of first element 1 and second element 2 has generated the electric power, control circuit 204 (or determination circuit 205) can determine whether push button 5 has been pressed or whether push button 5 has been released.

### (2) Embodiment 2

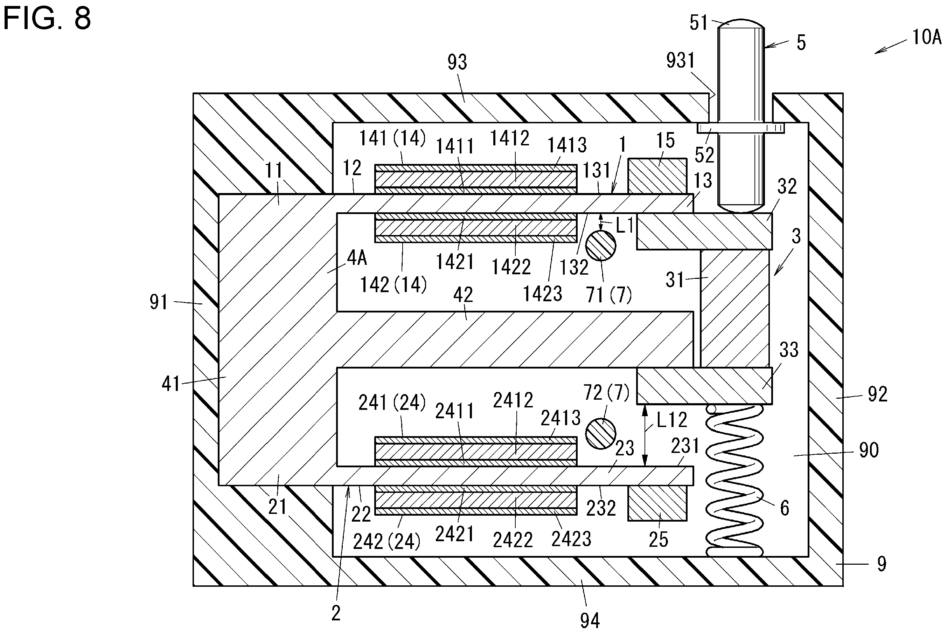

Power generation device 10A according to Embodiment 2 will be described with reference to Figs. 8 to 11. In power generation device 10A according to the present exemplary embodiment, elements that are substantially the same as those in power generation device 10 according to Embodiment 1 are assigned the same reference marks, and as such, description of the elements will be omitted where appropriate.

Power generation device 10A includes support body 4A instead of support body 4. Support body 4A includes shared magnetic path portion 42 in addition to main body portion 41 corresponding to support body 4 in power generation device 10 according to Embodiment 1.

Shared magnetic path portion 42 protrudes rightward from the vertical center of main body portion 41. Shared magnetic path portion 42 is substantially parallel to vibration portions 12, 22. In other words, first element 1 and second element 2 are arranged so as to face each other across shared magnetic path portion 42 which is formed of a magnetic material.

Shared magnetic path portion 42 is integrally formed with main body portion 41. The protruding length of shared magnetic path portion 42 from main body portion 41 is substantially the same as those of vibration portions 12, 22. Unlike vibration portions 12, 22, shared magnetic path portion 42 is so rigid as to be hard to curve (vibrate) in normal use.

In power generation device 10A according to the present exemplary embodiment, first element 1 and second element 2 are arranged side by side across shared magnetic path portion 42. First element 1, second element 2, and support body 4A (main body portion 41 and shared magnetic path portion 42) form an "E" shape as viewed from the front. In other words, in power generation device 10A according to the present exemplary embodiment, an E-shaped magnetic path including first piezoelectric vibrating power generation element 1, shared magnetic path portion 42, and second element 2 as viewed in a direction orthogonal to the alignment of first element 1 and second element 2. The E-shaped magnetic path includes: a first magnetic path including first element 1 and shared magnetic path portion 42; and a second magnetic path including second element 2 and shared magnetic path portion 42.

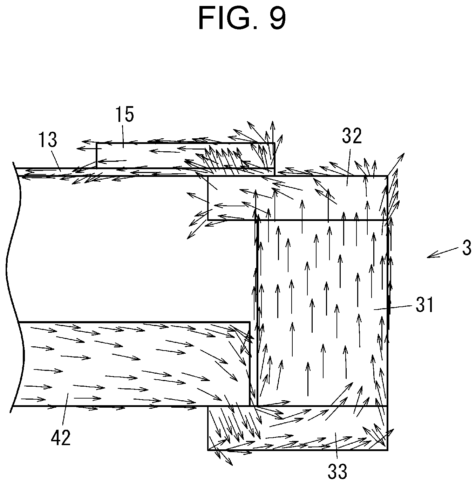

Furthermore, when movable element 3 is in the first position, first magnetic body 32 of movable element 3 contacts first element 1, and second magnetic body 33 of movable element 3 contacts shared magnetic path portion 42, as illustrated in Fig. 8. In other words, when movable element 3 is in the first position, a magnetic path including the first magnetic path and movable element 3 form a closed magnetic path (also hereinafter referred to as a "first closed magnetic path"). As illustrated in Fig. 9, a magnetic flux from permanent magnet 31 flows counterclockwise in the first closed magnetic path. Note that the arrows in Fig. 9 indicate the directions of the magnetic flux. In Fig. 9, the shapes of movable element 3, weights 15, 25, etc., are schematic.

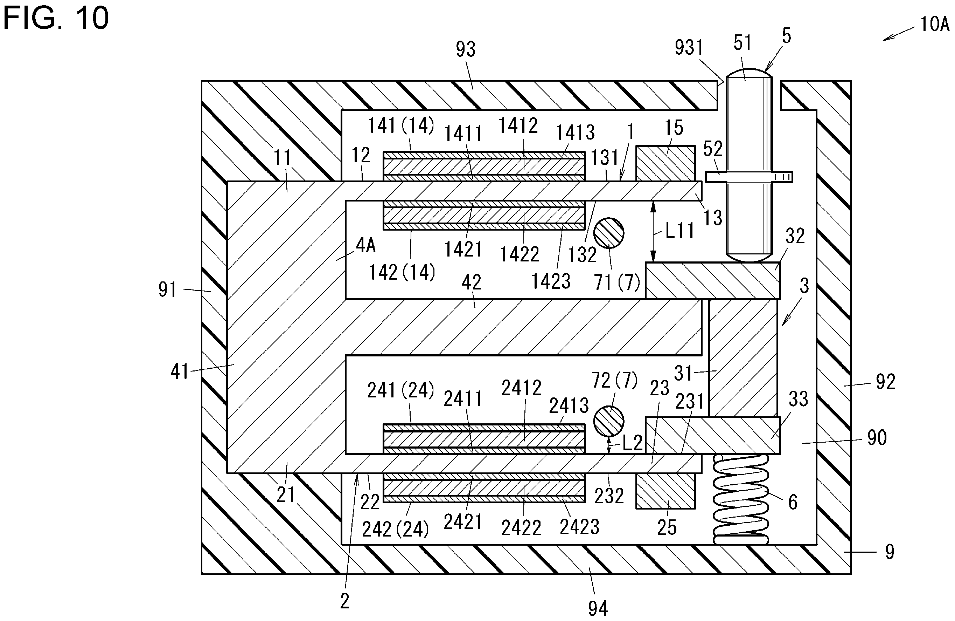

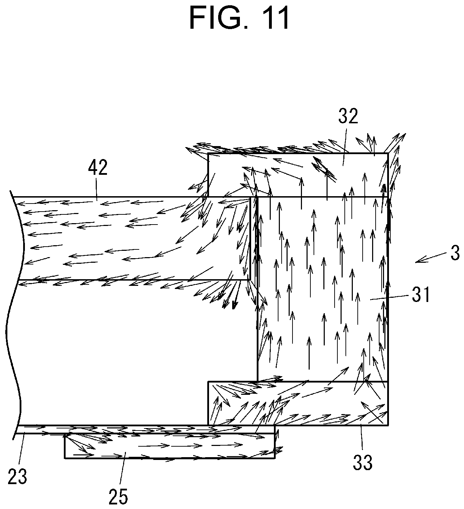

Furthermore, when movable element 3 is in the second position, first magnetic body 32 of movable element 3 contacts shared magnetic path portion 42, and second magnetic body 33 of movable element 3 contacts second element 2, as illustrated in Fig. 10. In other words, when movable element 3 is in the second position, a magnetic path including the second magnetic path and movable element 3 form a closed magnetic path (also hereinafter referred to as a "second closed magnetic path"). As illustrated in Fig. 11, a magnetic flux from permanent magnet 31 flows counterclockwise in the second closed magnetic path. Note that the arrows in Fig. 11 indicate the directions of the magnetic flux. In Fig. 11, the shapes of movable element 3, weights 15, 25, etc., are schematic.

In power generation device 10A according to the present exemplary embodiment, since support body 4A includes shared magnetic path portion 42, it is possible to reduce the impact that the magnetic flux of permanent magnet 31 has on the power generation by first element 1 and second element 2. This point will be described below with reference to Figs. 8 to 11, including comparison with power generation device 10 according to Embodiment 1.

In power generation device 10 according to Embodiment 1, when movable element 3 moves from the first position (refer to Fig. 1) to the second position (refer to Fig. 2), movable element 3 separates from first element 1 midway through the movement, vibration portion 12 vibrates (refer to Fig. 4), and power generator 14 generates electric power. At this time, beam 13 of vibration portion 12 is under a force directed toward movable element 3 based on the magnetic force from permanent magnet 31. Therefore, due to the impact of the magnetic force of permanent magnet 31, the vibrational amplitude of vibration portion 12 may be reduced, and the amount of power generation at power generator 14 may be reduced.

In contrast, in power generation device 10A according to the present exemplary embodiment, support body 4A includes shared magnetic path portion 42. Therefore, when movable element 3 moves from the first position to the second position, magnetic field lines from the N-pole face (upper surface) of permanent magnet 31 pass through shared magnetic path portion 42, the lower half of main body portion 41 of support body 4A, and beam 23 of second element 2, and return to the S-pole face (lower surface) of permanent magnet 31 (refer to Fig. 11). This means that when movable element 3 moves from the first position to the second position, a major part of the magnetic field lines from permanent magnet 31 passes through the closed magnetic path (second closed magnetic path). Thus, when movable element 3 moves to the second position, first element 1 is less likely to be affected by the magnetic force of permanent magnet 31. Accordingly, in power generation device 10A according to the present exemplary embodiment, when movable element 3 moves from the first position (refer to Fig. 8) to the second position (refer to Fig. 10), vibration portion 12 vibrates, and power generator 14 generates electric power, the vibrational amplitude of vibration portion 12 is less likely to be reduced due to the impact of the magnetic force of permanent magnet 31. Consequently, in power generation device 10A, it is possible to increase the amount of power generation at power generator 14 when movable element 3 is moving from the first position to the second position, as compared to power generation device 10. Note that in actuality, among the magnetic field lines from permanent magnet 31, magnetic field lines passing through a path including second element 2 gradually become dominant midway through the movement of movable element 3 from the first position to the second position. In other words, the impact that the magnetic force of permanent magnet 31 has on first element 1 can be gradually reduced even during the movement of movable element 3 from the first position to the second position.

Similarly, in power generation device 10 according to Embodiment 1, when movable element 3 moves from the second position (refer to Fig. 2) to the first position (refer to Fig. 1), vibration portion 22 vibrates, and power generator 24 generates electric power, the vibrational amplitude of vibration portion 22 may be reduced and the amount of power generation at power generator 24 may be reduced due to the impact of the magnetic force of permanent magnet 31.

In contrast, in power generation device 10A according to the present exemplary embodiment, when movable element 3 moves from the second position to the first position, the magnetic field lines from the N-pole face (upper surface) of permanent magnet 31 pass through first element 1, the upper half of main body portion 41 of support body 4A, and shared magnetic path portion 42 and return to the S-pole face (lower surface) of permanent magnet 31 (refer to Fig. 10). This means that when movable element 3 moves from the second position to the first position, a major part of the magnetic field lines from permanent magnet 31 passes through the closed magnetic path (first closed magnetic path). Thus, when movable element 3 moves to the first position, second element 2 is less likely to be affected by the magnetic force of permanent magnet 31. Accordingly, in power generation device 10A according to the present exemplary embodiment, when movable element 3 moves from the second position (refer to Fig. 10) to the first position (refer to Fig. 8), vibration portion 22 vibrates, and power generator 24 generates electric power, the vibrational amplitude of vibration portion 22 is less likely to be reduced due to the impact of the magnetic force of permanent magnet 31. Consequently, in power generation device 10A, it is possible to increase the amount of power generation at power generator 24 when movable element 3 moves from the second position to the first position, as compared to power generation device 10. Note that among the magnetic field lines from permanent magnet 31, magnetic field lines passing through a path including first element 1 gradually become dominant midway through the movement of movable element 3 from the second position to the first position. In other words, the impact that the magnetic force of permanent magnet 31 has on second element 2 can be gradually reduced even during the movement of movable element 3 from the second position to the first position.

Furthermore, in power generation device 10A according to the present exemplary embodiment, since support body 4 includes shared magnetic path portion 42, it is possible to assist the push operation that is performed by an operator. Specifically, when movable element 3 is in the first position (refer to Fig. 8), a magnetic flux from permanent magnet 31 flows counterclockwise in the first closed magnetic path. When movable element 3 moves downward from the first position, second magnetic body 33 moves downward, and a gap is created between shared magnetic path portion 42 and second magnetic body 33, resulting in an increase in the magnetic resistance of a magnetic circuit (referred to as a "first magnetic circuit") passing through first element 1 and shared magnetic path portion 42. Meanwhile, when first magnetic body 32 moves downward, a gap between first magnetic body 32 and shared magnetic path portion 42 is reduced, and when second magnetic body 33 moves downward, a gap between second magnetic body 33 and second element 2 is reduced. Therefore, the magnetic resistance of a magnetic circuit (referred to as a "second magnetic circuit") passing through second element 2 and shared magnetic path portion 42 is reduced. Subsequently, when movable element 3 moves further downward and the magnetic resistance of the second magnetic circuit becomes less than the magnetic resistance of the first magnetic circuit, the magnetic flux from permanent magnet 31 preferentially flows through the second magnetic circuit. Accordingly, a force of attraction occurs between first magnetic body 32 of movable element 3 and shared magnetic path portion 42, and a force of attraction occurs between second magnetic body 33 of movable element 3 and second element 2, causing movable element 3 to be drawn downward. Thus, the push operation that is performed by an operator is assisted.

### (3) Embodiment 3

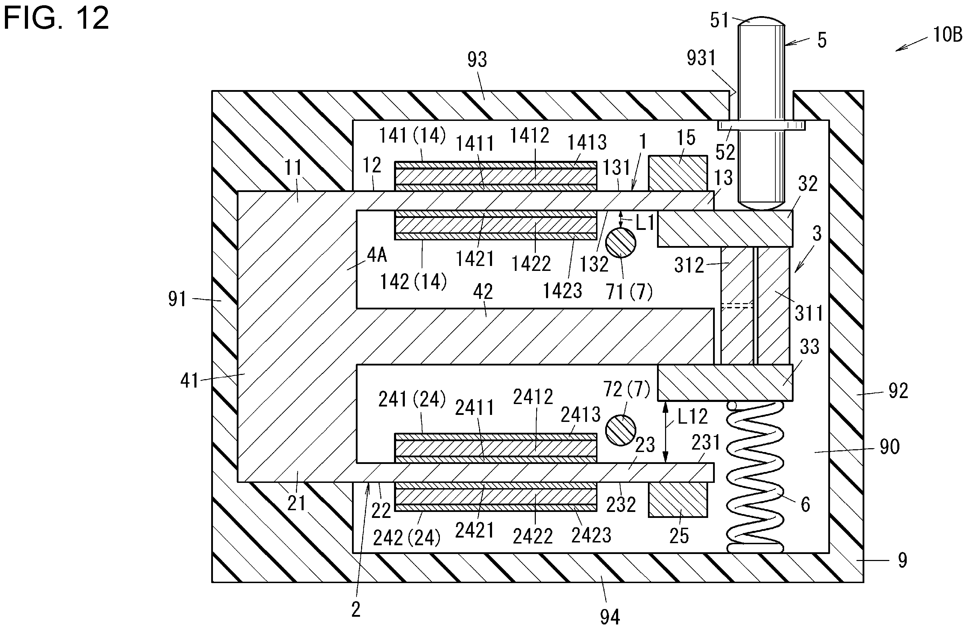

Power generation device 10B according to Embodiment 3 will be described with reference to Figs. 12 to 14. In power generation device 10B according to the present exemplary embodiment, elements that are substantially the same as those in power generation device 10A according to Embodiment 2 are assigned the same reference marks, and as such, description of the elements will be omitted where appropriate.

In power generation device 10B, movable element 3 includes first permanent magnet 311 and second permanent magnet 312 instead of permanent magnet 31.

In movable element 3, first permanent magnet 311 is located on the right-hand side, and second permanent magnet 312 is located on the left-hand side. In other words, second permanent magnet 312 is more proximal to shared magnetic path portion 42 than first permanent magnet 311 is.

First permanent magnet 311 has a N-pole face (first pole surface) as an upper surface and a S-pole face (second pole surface) as a lower surface. Second permanent magnet 312 has one side polarized to have two polarities such that the upper half of the left surface is a N-pole face (first pole surface), the lower half of the left surface is a S-pole face (second pole surface), the upper half of the right surface is a S-pole face (second pole surface), and the lower half of the right surface is a N-pole face (first pole surface).

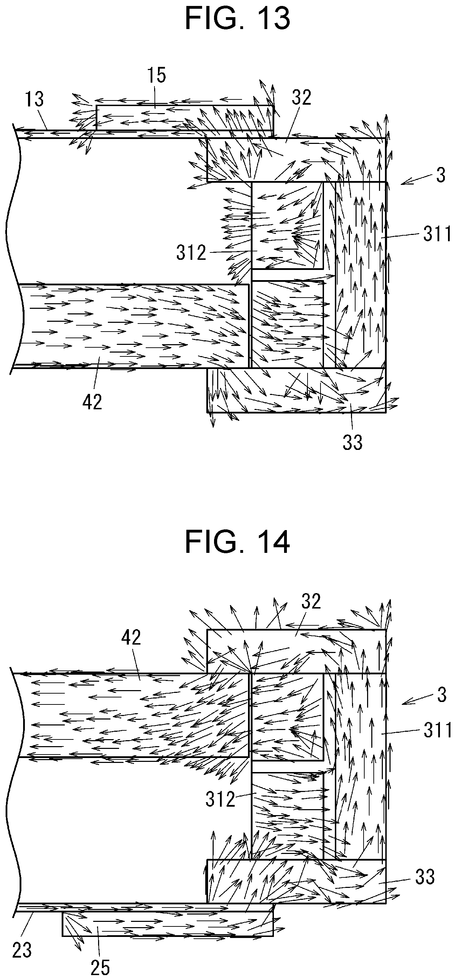

The features of power generation device 10B according to the present exemplary embodiment will be described below with reference to Figs. 12 to 14, including comparison with power generation device 10A according to Embodiment 2. Note that the arrows in Figs. 13 and 14 indicate the directions of the magnetic flux. In Figs. 13 and 14, the shapes of movable element 3, weights 15, 25, etc., are schematic.

In power generation device 10A according to Embodiment 2, permanent magnet 31 is polarized so that the upper surface is a north pole and the lower surface is a south pole. When movable element 3 is in the first position, the magnetic field lines entering movable element 3 through shared magnetic path portion 42 enter second magnetic body 33 through the upper surface of second magnetic body 33 by way of the leading end (right end) of shared magnetic path portion 42 and enter the lower surface (S-pole face) of permanent magnet 31 through the upper surface of second magnetic body 33, as illustrated in Fig. 9. Therefore, at the boundary between shared magnetic path portion 42 and second magnetic body 33, the directions of the magnetic field lines change abruptly (from rightward to downward), and magnetic flux saturation is likely to occur. When the magnetic flux saturation occurs, the force of attraction between movable element 3 and shared magnetic path portion 42 may be reduced.

In contrast, in power generation device 10B according to the present exemplary embodiment, when movable element 3 is in the first position, part of the magnetic field lines entering movable element 3 through shared magnetic path portion 42 enters second magnetic body 33 through the leading end (right end) of shared magnetic path portion 42, and the rest of the magnetic field lines enters second permanent magnet 32 through the left surface of second permanent magnet 312, as illustrated in Fig. 13. This means that second permanent magnet 312 forms a bypass path in which the magnetic field lines pass. Therefore, in power generation device 10B according to the present exemplary embodiment, the magnetic flux saturation is less likely to occur than in power generation device 10A according to Embodiment 2. Thus, it is possible to improve the force of attraction between movable element 3 and shared magnetic path portion 42.

Similarly, in power generation device 10B according to the present exemplary embodiment, when movable element 3 is in the second position, part of the magnetic field lines entering shared magnetic path portion 42 through movable element 3 enters shared magnetic path portion 42 through the leading end (left end) of first magnetic body 32, and the rest of the magnetic field lines enters shared magnetic path portion 42 through second permanent magnet 312. This means that second permanent magnet 312 forms a bypass path in which the magnetic field lines pass. Therefore, in power generation device 10B according to the present exemplary embodiment, the magnetic flux saturation is less likely to occur than in power generation device 10A according to Embodiment 2. Thus, it is possible to improve the force of attraction between movable element 3 and shared magnetic path portion 42.

### (4) Embodiment 4

### (4. 1) Power Generation Device

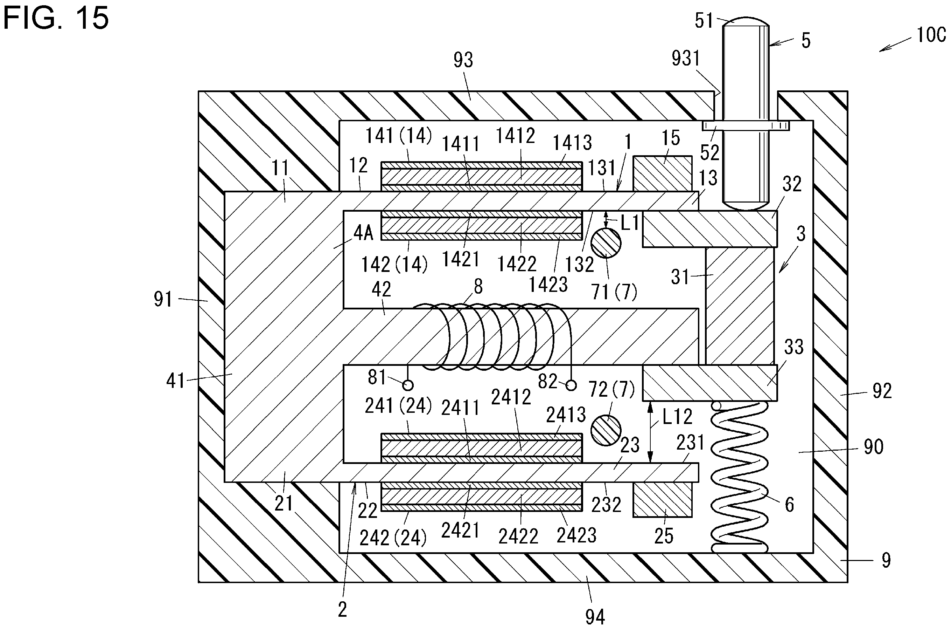

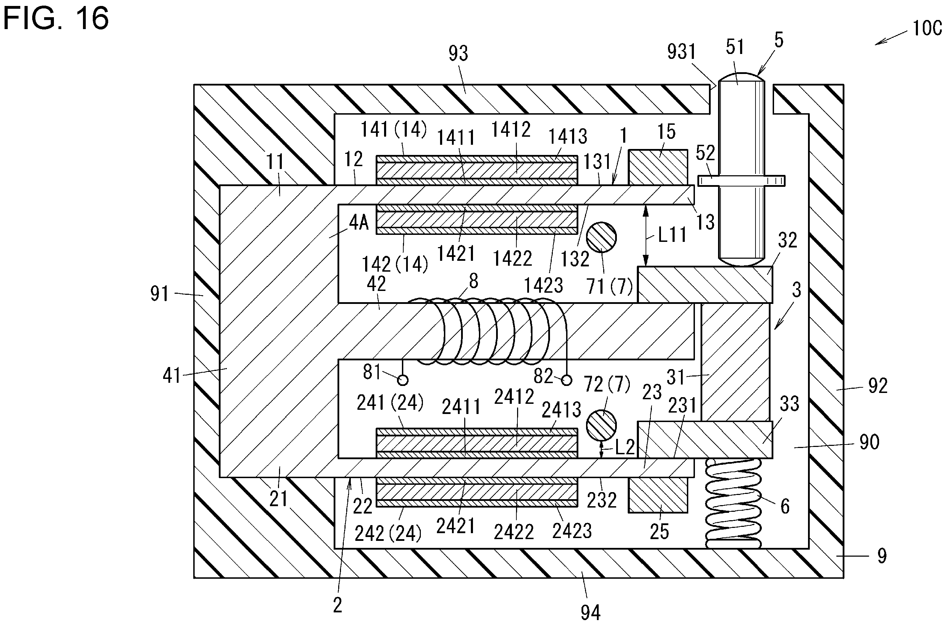

Power generation device 10C according to Embodiment 4 will be described with reference to Figs. 15 and 16. In power generation device 10C according to the present exemplary embodiment, elements that are substantially the same as those in power generation device 10A according to Embodiment 1 are assigned the same reference marks, and as such, description of the elements will be omitted where appropriate.

As illustrated in Fig. 15, power generation device 10C further includes coil 8. Coil 8 has first end 81 and second end 82 at opposite ends. Coil 8 is disposed in the E-shaped magnetic path. Here, coil 8 is wound around shared magnetic path portion 42 of support body 4. Coil 8 constitutes a power generator (third power generator) that generates electric power according to movement of movable element 3.

Hereinafter, the power generation by coil 8 will be briefly described.

When movable element 3 is in the first position (refer to Fig. 15), the magnetic flux from permanent magnet 31 flows counterclockwise in the first closed magnetic path (first magnetic circuit) (refer to Fig. 13). Specifically, the magnetic flux from permanent magnet 31 flows leftward in beam 13 of first element 1 from the N-pole face (upper surface) of permanent magnet 31, flows downward in main body portion 41 of support body 4, flows rightward in shared magnetic path portion 42, and returns to the S-pole face (lower surface) of permanent magnet 31. Thus, the rightward magnetic flux flows inside coil 8.

In this state, when movable element 3 moves downward according to the push operation on push button 5 performed by an operator, a gap is created between movable element 3 (second magnetic body 33) and shared magnetic path portion 42. Accordingly, the magnetic resistance of the aforementioned magnetic circuit (first magnetic circuit) increases, and the rightward magnetic flux flowing in shared magnetic path portion 42 changes (decreases). When the magnetic flux flowing in coil 8 changes, coil 8 generates an electric current by electromagnetic induction.

On the other hand, when movable element 3 is in the second position (refer to Fig. 16) as a result of an operator pressing push button 5, the magnetic flux from permanent magnet 31 flows counterclockwise in the second closed magnetic path (second magnetic circuit) (refer to Fig. 14). Specifically, the magnetic flux from permanent magnet 31 flows leftward in shared magnetic path portion 42 from the N-pole face (upper surface) of permanent magnet 31, flows downward in main body portion 41 of support body 4, flows rightward in beam 23 of second element 2, and returns to the S-pole face (lower surface) of permanent magnet 31. Thus, the leftward magnetic flux, that is, the magnetic flux flowing in the direction opposite to the direction thereof with movable element 3 in the first position, flows inside coil 8.

In this state, when the operator ends the push operation on push button 5, movable element 3 moves upward, and a gap is created between movable element 3 (first magnetic body 32) and shared magnetic path portion 42. Accordingly, the magnetic resistance of the aforementioned magnetic circuit (second magnetic circuit) increases, and the leftward magnetic flux flowing in shared magnetic path portion 42 changes (decreases). When the magnetic flux flowing in coil 8 changes, coil 8 generates an electric current by electromagnetic induction. The direction of the electric current generated by coil 8 at this time is opposite to the direction of the electric current generated when the push operation is performed on push button 5 (when movable element 3 moves from the first position to the second position).

At this time, in power generation device 10C according to the present exemplary embodiment, when movable element 3 moves, not only first power generator 14 and second power generator 24, but also the third power generator (coil 8) generates electric power. Thus, with power generation device 10C according to the present exemplary embodiment, it is possible to further improve power generation efficiency.

### (4.2) First Example of Input Device

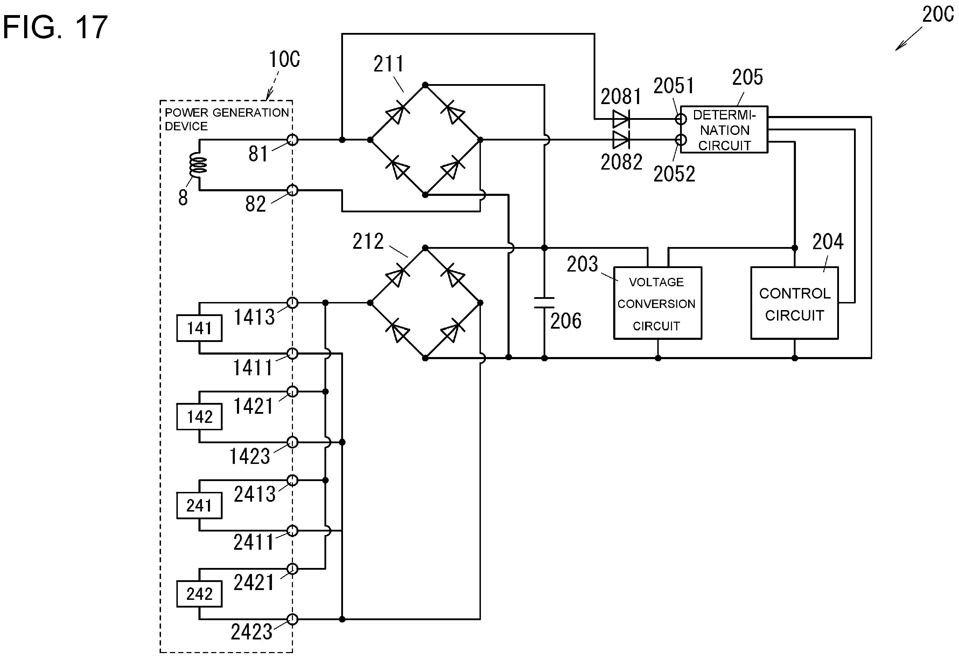

Next, one example (first example) of input device 20C including power generation device 10C will be described with reference to Fig. 17. In input device 20C, elements that are substantially the same as those in input device 20 according to Embodiment 1 are assigned the same reference marks, and as such, description of the elements will be omitted where appropriate.

Input device 20C includes coil current rectifier circuit 211, piezoelectric current rectifier circuit 212, voltage conversion circuit 203, determination circuit 205, power storage element 206, first rectifier 2081, and second rectifier 2082, in addition to power generation device 10C and control circuit 204.

Coil current rectifier circuit 211 adjusts the electric current supplied from coil 8 so that the electric current flows in one direction. Coil current rectifier circuit 211 is a what is called a diode bridge in which four didoes are connected in series-parallel.

One input terminal among two input terminals of coil current rectifier circuit 211 is connected to first end 81 of coil 8. The other input terminal among the two input terminals of coil current rectifier circuit 211 is connected to second end 82 of coil 8.

Furthermore, first end 81 of coil 8 is connected to first input terminal 2051 of determination circuit 205 via the diode serving as first rectifier 2081. Second end 82 of coil 8 is connected to second input terminal 2052 of determination circuit 205 via the diode serving as second rectifier 2082.

Power storage element 206 is connected between two output terminals of coil current rectifier circuit 211.

Piezoelectric current rectifier circuit 212 adjusts the electric current supplied from first power generator 14 of first element 1 and second power generator 24 of second element 2 so that the electric current flows in one direction. Piezoelectric current rectifier circuit 212 is a what is called a diode bridge in which four didoes are connected in series-parallel.

One input terminal among two input terminals of piezoelectric current rectifier circuit 212 is connected to second electrode (upper electrode) 1413 of first piezoelectric converter 141, first electrode (upper electrode) 1421 of second piezoelectric converter 142, second electrode (upper electrode) 2413 of third piezoelectric converter 241, and first electrode (upper electrode) 2421 of fourth piezoelectric converter 242. The other input terminal among the two input terminals of piezoelectric current rectifier circuit 212 is connected to first electrode (lower electrode) 1411 of first piezoelectric converter 141, second electrode (lower electrode) 1423 of second piezoelectric converter 142, first electrode (lower electrode) 2411 of third piezoelectric converter 241, and second electrode (lower electrode) 2423 of fourth piezoelectric converter 242.

This means that both the electric current generated at first power generator 14 and the electric current generated at second power generator 24 are input to piezoelectric current rectifier circuit 212.

Power storage element 206 is connected between two output terminals of piezoelectric current rectifier circuit 212. Unlike input device 20, input terminal 20C has no piezoelectric rectifiers (diodes) connected between the rectifier circuit and power storage element 206.

Both ends of power storage element 206 are connected to voltage conversion circuit 203, and voltage conversion circuit 203 is connected to control circuit 204.

Voltage conversion circuit 203 generates an operating voltage for control circuit 204 from electric charge stored in power storage element 206. Control circuit 204 operates at the operating voltage supplied from voltage conversion circuit 203, and performs a desired function (for example, a notification function using radio communication).

When power generation device 10C generates electric power, determination circuit 205 determines which of first element 1 and second element 2 has generated the electric power. Determination circuit 205 performs this determination by comparing the value of a voltage at first input terminal 2051 and the value of a voltage at second input terminal 2052, for example. Specifically, the direction of the electric current generated at coil 8 when movable element 3 moves from the first position to the second position and the direction of the electric current generated at coil 8 when movable element 3 moves from the second position to the first position are opposite to each other; this depends on which of first end 81 and second end 82 has high potential. Therefore, by comparing the value of a voltage at first input terminal 2051 and the value of a voltage at second input terminal 2052, determination circuit 205 can determine a direction in which movable element 3 is moving. When the direction in which movable element 3 is moving is known, it is clear which of first element 1 and second element 2 is vibrating. Thus, determination circuit 205 can determine which of first element 1 and second element 2 has generated the electric power.

Thus, input device 20C includes determination circuit 205 which determines, on the basis of the direction of the electric current generated at coil 8, which of first element 1 and second element 2 has generated the electric power. By finding a source that has generated the electric power, input device 20C can determine, for example, whether push button 5 has been pressed or whether push button 5 has been released.

Furthermore, in input device 20C, according to the direction of the electric current generated at coil 8, determination circuit 205 finds a source that has generated the electric power. Therefore, unlike input device 20 according to Embodiment 1, input device 20C does not require the diodes serving as rectifiers (2071, 2072). Thus, electric current loss due to the diodes can be reduced.

Note that the power storage element to be connected to the output terminal of piezoelectric current rectifier circuit 212 and the power storage element to be connected to the output terminal of coil current rectifier circuit 211 may be separate. In other words, a path in which the electric power generated at first power generator 14 and second power generator 24 is supplied to control circuit 204 and a path in which the electric power generated at the third power generator (coil 8) is supplied to control circuit 204 may be different. This makes it possible to improve the operation redundancy of control circuit 204.

### (4. 3) Second Example of Input Device

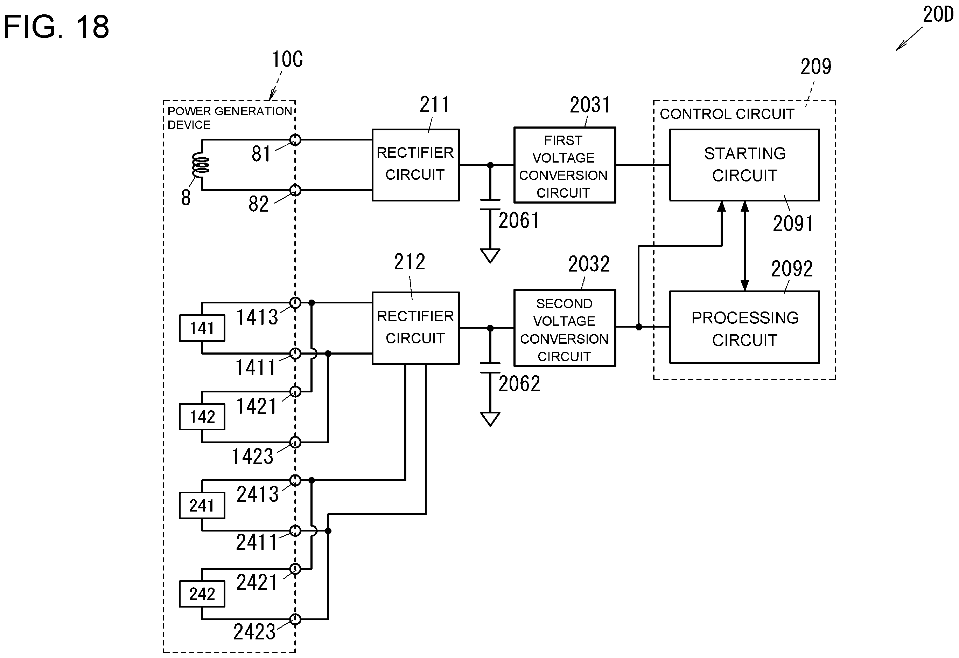

Next, input device 20D according to another example (second example) which includes power generation device 10C will be described with reference to Fig. 18. In input device 20D, elements that are substantially the same as those in input device 20C according to the first example are assigned the same reference marks, and as such, description of the elements will be omitted where appropriate.

Input device 20D includes power generation device 10C, coil current rectifier circuit 211, piezoelectric current rectifier circuit 212, first voltage conversion circuit 2031, second voltage conversion circuit 2032, first power storage element 2061, second power storage element 2062, and control circuit 209. Although not illustrated in the drawings, input device 20D further includes determination circuit 205, first rectifier 2081, and second rectifier 2082 (refer to Fig. 17).

Each of coil current rectifier circuit 211 and piezoelectric current rectifier circuit 212 is a diode bridge, for example.

First power storage element 2061 is connected between two output terminals of coil current rectifier circuit 211. Both ends of first power storage element 2061 are connected to first voltage conversion circuit 2031, and first voltage conversion circuit 2031 is connected to control circuit 209.

Second power storage element 2062 (a power storage element different from first power storage element 2061) is connected between the two output terminals of piezoelectric current rectifier circuit 212. Both ends of second power storage element 2062 are connected to second voltage conversion circuit 2032, and second voltage conversion circuit 2032 is connected to control circuit 209.

Each of first voltage conversion circuit 2031 and second voltage conversion circuit 2032 is a DC/DC converter or a three-terminal regulator, for example.

Control circuit 209 includes starting circuit 2091 and processing circuit 2092.

Starting circuit 2091 is connected to first voltage conversion circuit 2031. When the voltage supplied from first voltage conversion circuit 2031 exceeds a predetermined threshold voltage, starting circuit 2091 operates and transmits a start signal to processing circuit 2092.

Processing circuit 2092 is connected to second voltage conversion circuit 2032. Processing circuit 2092 operates at the operating voltage supplied from second voltage conversion circuit 2032, and performs a predetermined function (for example, a notification function). When processing circuit 2092 receives the start signal from starting circuit 2091, processing circuit 2092 performs the function at the operating voltage supplied from second voltage conversion circuit 2032. In other words, even when processing circuit 2092 is supplied with the operating voltage from second voltage conversion circuit 2032, processing circuit 2092 does not perform the function until processing circuit 2092 receives the start signal from starting circuit 2091.

As already mentioned, power generation device 10C included in input device 20D according to the present invention includes two piezoelectric vibrating power generation elements (first element 1 and second element 2). One of these two piezoelectric vibrating power generation elements is attracted and attached to movable element 3, and thus vibration of the piezoelectric vibrating power generation element is restricted. For example, when movable element 3 is in the first position, first element 1 is attracted and attached to the upper surface of first magnetic body 32 of movable element 3, and thus vibration of first element 1 is restricted. When movable element 3 is in the second position, second element 2 is attracted and attached to the upper surface of second magnetic body 33 of movable element 3, and thus vibration of second element 2 is restricted. Meanwhile, the position of the other piezoelectric vibrating power generation element (that is second element 2 when movable element 3 is in the first position or first element 1 when movable element 3 is in the second position) is not fixed. Therefore, the other piezoelectric vibrating power generation element may vibrate and generate electric power due to factors other than the movement of movable element 3 following the operation of pushing or releasing push button 5, for example, due to vibration of housing 9. For example, in input device 20 according to Embodiment 1, control circuit 204 (refer to Fig. 7) may perform a specific function (such as a notification function using radio communication) according to the electric power generated by the other piezoelectric vibrating power generation element while movable element 3 is not under the pressing force of push button 5. Note that although not illustrated in Fig. 7, control circuit 204 includes processing circuit 2092 which performs a specific function, as illustrated in Fig. 18.

This means that in input device 20D according to the present exemplary embodiment, control circuit 209 includes starting circuit 2091 in order to minimize the aforementioned malfunctions. Processing circuit 2092 does not perform a specific function until processing circuit 2092 receives the start signal from starting circuit 2091. Therefore, in input device 20D (refer to Fig. 18) according to the present exemplary embodiment, in a situation in which the push operation has not been performed on push button 5, the likelihood of control circuit 204 performing a specific function (for example, a notification function using radio communication) is reduced.

Input device 20D according to the present exemplary embodiment includes starting circuit 2091 (malfunction prevention circuit). Starting circuit 2091 restricts processing circuit 2092 from performing a specific function in a specific situation. The specific situation is a state in which movable element 3 is not under the pressing force of an external unit (push button 5) and electric power is generated at power generation device 10 (10A to 10C). When starting circuit 2091 is supplied with an electric current from coil 8, starting circuit 2091 allows processing circuit 2092 to perform a specific function.

Note that starting circuit 2091 may monitor an output voltage at second voltage conversion circuit 2032. Starting circuit 2091 may transmit the start signal to processing circuit 2092 to cause processing circuit 2092 to operate only when the output voltage at second voltage conversion circuit 2032 is greater than or equal to a voltage required for the operation of processing circuit 2092.

### (5) Variations

Each of the above-described exemplary embodiments is merely one of various exemplary embodiments of the present disclosure. Various changes can be made to each of the above-described exemplary embodiments according to the design or the like as long as the object of the present disclosure can be achieved. Variations of the above-described exemplary embodiments will be detailed below. The variations described below can be combined and applied as appropriate.

In one variation, input device 20 (refer to Fig. 7) according to Embodiment 1 may further include a malfunction preventer. The malfunction preventer is a circuit or a structure that restricts a predetermined operation in a specific situation. Specifically, starting circuit 2091 (malfunction prevention circuit) described above is one example of the malfunction preventer. Furthermore, the malfunction preventer does not need to be included in control circuit 204 and may be provided as a structure. The specific situation is a state in which movable element 3 is not under the pressing force of an external unit (push button 5) and electric power is generated at power generation device 10 (10A to 10C). As one example, the malfunction preventer may be a structure that restricts vibration of one of two piezoelectric vibrating power generation elements 1, 2 that is not attracted and attached to movable element 3. As one example, the malfunction preventer may be a structure that when push button 5 is not pressed, restricts vibration of the two piezoelectric vibrating power generation elements, and when push button 5 is pressed, allows the two piezoelectric vibrating power generation elements to vibrate.

In one variation, first power generator 14 may include only one of first piezoelectric converter 141 and second piezoelectric converter 142 and may include a piezoelectric converter different from first piezoelectric converter 141 and second piezoelectric converter 142.

In one variation, second power generator 24 may include only one of third piezoelectric converter 241 and fourth piezoelectric converter 242 and may include a piezoelectric converter different from third piezoelectric converter 241 and fourth piezoelectric converter 242.

In one variation, coil 8 may be disposed in a position different from the position of shared magnetic path portion 42 in the E-shaped magnetic path. For example, coil 8 may include a first coil and a second coil. The first coil is wound around the upper half portion of main body portion 41 and generates an electric current according to a change in the magnetic flux passing through this portion, for example. The second coil is wound around the lower half portion of main body portion 41 and generates an electric current according to a change in the magnetic flux passing through this portion, for example.

In one variation, the pole faces of second permanent magnet 312 in power generation device 10B are not limited to the example in Embodiment 2. For example, second permanent magnet 312 may be polarized so that the upper half of the left surface is a N-pole face (first pole surface), the lower half of the left surface is a S-pole face (second pole surface), the upper surface is a S-pole face (second pole surface), and the lower surface is a N-pole face (first pole surface). Furthermore, in one variation, movable element 3 may include a magnetic body instead of second permanent magnet 312.

In one variation, power generation devices 10, 10A to 10C may include, instead of push button 5, other operation portions such as a slide button. Furthermore, power generation devices 10, 10A to 10C may include, instead of return portion 6, a push button disposed so as to protrude from lower wall 94 of housing 9 and configured to move movable element 3 from the second position to the first position according to a push operation performed by an operator.

In one variation, for example, housing 9 may include a restricting structure that restricts movable element 3 from moving further downward from the second position.

In one variation, power generation devices 10, 10A to 10C do not need to include first stopper 71 or second stopper 72.

In one example, input device 20 may include one of power generation devices 10A to 10C instead of power generation device 10.

### REFERENCE MARKS IN THE DRAWINGS

- 1: first piezoelectric vibrating power generation element
- 10, 10A-10C: power generation device
- 11, 21: support portion
- 12, 22: vibration portion
- 14, 24: power generation portion
- 141: first piezoelectric converter
- 1412, 1422: piezoelectric body
- 1411: first electrode (lower electrode)
- 1413: second electrode (upper electrode)
- 142: second piezoelectric converter
- 1421: first electrode (upper electrode)
- 1423: second electrode (lower electrode)
- 2: second piezoelectric vibrating power generation element
- 2412, 2422: piezoelectric body
- 2411: first electrode (lower electrode)
- 2413: second electrode (upper electrode)
- 2421: first electrode (upper electrode)
- 2423: second electrode (lower electrode)
- 3: movable element
- 4, 4A: support body
- 41: main body portion
- 42: shared magnetic path portion
- 5: push button
- 51: operation body
- 6: return portion
- 42: shared magnetic path portion
- 71: first stopper
- 72: second stopper
- 8: coil
- 20, 20C, 20D: input device
- 201: first rectifier circuit
- 202: second rectifier circuit
- 204, 209: control circuit
- 205: determination circuit
- 2051: first input terminal
- 2052: second input terminal

## Claims

1. An input device comprising:
a power generation device (10, 10A-10C) comprising:
a first piezoelectric vibrating power generation element (1) configured to vibrate to generate electric power;
a second piezoelectric vibrating power generation element (2) located lower than the first power generation element (1) and configured to vibrate to generate electric power; and
a movable element (3), formed of a magnetic material, and being configured to attract the first power generation element (1) downward when the movable element (3) is moving downward, and attract the second power generation element (2) upward when the movable element (3) is moving upward, wherein
the first power generation element (1) is configured to vibrate as a result of the downward movement of the movable element (3), and
the second power generation element (2) vibrates as a result of the upward movement of the movable element (3),
**characterized in that**
a control circuit (204, 209) is configured to operate using the electric power generated at the power generation device (10, 10A-10C); and **in that**
a determination circuit (205) is configured to, when the electric power is generated at the power generation device (10, 10A-10C), determine at which of the first power generation element (1) and the second power generation element (2) the electric power has been generated.

2. The input device according to claim 1, further comprising:
a first rectifier circuit (201) configured to adjust an electric current supplied from the first power generation element (1), to cause the electric current to flow in one direction; and
a second rectifier circuit (202) configured to adjust an electric current supplied from the second power generation element (2), to cause the electric current to flow in one direction, wherein
the determination circuit (205) includes a first input terminal (2051) connected to the first rectifier circuit (201) and a second input terminal (2052) connected to the second rectifier circuit (202).

3. The input device according to claim 1 or 2, further comprising:
a malfunction preventer, wherein
the malfunction preventer is configured to restrict the input device from performing a predetermined operation in a specific situation, and
the specific situation is a state in which the movable element (3) is not under an external pressing force and the electric power is generated at the power generation device (10, 10A-10C).

4. The input device according to claim 1, further comprising:
a support body (4, 4A) formed of a magnetic material, wherein the support body (4, 4A) includes a main body portion (41) and a shared magnetic path portion (42) extending from the main body portion (41),
each of one end of the first power generation element (1), one end of the shared magnetic path portion (42), and one end of the second power generation element (2) is connected to the main body portion (41),
the first power generation element (1), the shared magnetic path portion (42), and the second power generation element (2) are spaced and arranged in the following order from top to bottom: the first power generation element (1); the shared magnetic path portion (42); and the second power generation element (2),
when the movable element (3) is in the first position, the first power generation element (1), the shared magnetic path portion (42), the main body portion (41), and the movable element (3) form a first closed magnetic path, and
the movable element (3) is configured such that, when being in the second position, the second power generation element (2), the shared magnetic path portion (42), the main body portion (41), and the movable element (3) form a second closed magnetic path, and
a coil (8) on a magnetic path including the support body (4, 4A), the first power generation element (1), and the second power generation element (2), or the coil (8) is wound around the shared magnetic path portion (42) of the support body (4, 4A),
wherein
the determination circuit (205) is configured to determine, based on a direction of an electric current generated at the coil (8), at which of the first power generation element (1) and the second power generation element (2) the electric power has been generated.

5. The input device according to claim 4, wherein
the control circuit (204, 209) includes a malfunction prevention circuit connected to the coil (8),
the malfunction prevention circuit is configured to restrict the control circuit (204, 209) from performing a predetermined operation in a specific situation,
the specific situation is a state in which the movable element (3) is not under an external pressing force and the electric power is generated at the power generation device (10, 10A-10C), and
the malfunction prevention circuit is configured such that, when supplied with the electric current from the coil (8), the malfunction prevention circuit allows the control circuit (204, 209) to perform the predetermined operation.

6. The input device according to claim 1, wherein
the movable element (3) moves between a first position and a second position located lower than the first position,
when the movable element (3) is in the first position, the movable element (3) is in contact with the first power generation element (1) and is separate from the second power generation element (2), and
the movable element (3) is is configured such that, when being in the second position, the movable element (3) is separate from the first power generation element (1) and is in contact with the second power generation element (2).

7. The input device according to claim 6, further comprising:
a push button (5) configured to, when pressed, move the movable element (3) downward; and
a return portion (6) configured to apply an upward force to the movable element (3).

8. The input device according to claim 6 or 7, further comprising:
at least one of a first stopper (71) and a second stopper (72) disposed lower than the first stopper (71), wherein
the movable element (3) is configured such that, when moved downward from the first position, the first stopper (71) allows the first power generation element (1) to separate from the movable element (3) before the movable element (3) contacts the second power generation element (2), and
the movable element (3) is configured such that, when moved upward from the second position, the second stopper (72) allows the second power generation element (2) to separate from the movable element (3) before the movable element (3) contacts the first power generation element (1).

9. The input device according to any one of claims 6 to 8, further comprising:
a support body (4, 4A) formed of a magnetic material, wherein
the support body (4, 4A) includes a main body portion (41) and a shared magnetic path portion (42) extending from the main body portion (41),
each of one end of the first power generation element (1), one end of the shared magnetic path portion (42), and one end of the second power generation element (2) is connected to the main body portion (41),
the first power generation element (1), the shared magnetic path portion (42), and the second power generation element (2) are spaced and arranged in the following order from top to bottom: the first power generation element (1); the shared magnetic path portion (42); and the second power generation element (2),
the movable element (3) is configured such that, when being in the first position, the first power generation element (1), the shared magnetic path portion (42), the main body portion (41), and the movable element (3) form a first closed magnetic path, and
the movable element (3) is configured such that, when being in the second position, the second power generation element (2), the shared magnetic path portion (42), the main body portion (41), and the movable element (3) form a second closed magnetic path.

10. The input device according to claim 9, further comprising:
a coil (8) on a magnetic path including the support body (4, 4A), the first power generation element (1), and the second power generation element (2).

11. The input device according to claim 10, wherein
the coil (8) is wound around the shared magnetic path portion (42) of the support body (4, 4A).

12. A power generation device comprising :
a first piezoelectric vibrating power generation element (1) configured to vibrate to generate electric power;
a second piezoelectric vibrating power generation element (2) located lower than the first power generation element (1) and configured to vibrate to generate electric power; and
a movable element (3) configured to attract the first power generation element (1) downward when the movable element (3) is moving downward, and attract the second power generation element (2) upward when the movable element (3) is moving upward, wherein
the first power generation element (1) is configured to vibrate as a result of the downward movement of the movable element (3), and
the second power generation element (2) is configured to vibrate as a result of the upward movement of the movable element (3),
the movable element (3) is configured to move between a first position and a second position located lower than the first position,
the movable element (3) is configured such that, when being in the first position, the movable element (3) is in contact with the first power generation element (1) and is separate from the second power generation element (2), and
the movable element (3) is configured such that, when being in the second position, the movable element (3) is separate from the first power generation element (1) and is in contact with the second power generation element (2),
a support body (4, 4A) formed of a magnetic material, wherein
the support body (4, 4A) includes: a main body portion (41); and a shared magnetic path portion (42) extending from the main body portion (41),
each of one end of the first power generation element (1), one end of the shared magnetic path portion (42), and one end of the second power generation element (2) is connected to the main body portion (41),
the first power generation element (1), the shared magnetic path portion (42), and the second power generation element (2) are spaced and arranged in the following order from top to bottom: the first power generation element (1); the shared magnetic path portion (42); and the second power generation element (2), a coil (8) is wound around the shared magnetic path portion (42) of the support body (4, 4A),
**characterized in that** the movable element (3) is configured such that, when being in the first position, the first power generation element(1), the shared magnetic path portion (42), the main body portion (41), and the movable element (3) form a first closed magnetic path,
**in that** the movable element (3) is configured such that, when being in the second position, the second power generation element (2), the shared magnetic path portion (42), the main body portion (41), and the movable element (3) form a second closed magnetic path, and **in that** the coil (8) is located on a magnetic path including the support body (4, 4A), the first power generation element (1), and the second power generation element (2).

13. The power generation device according to the preceding claim, further comprising :
a push button (5) configured to, when pressed, move the movable element (3) downward; and
a return portion (6) configured to apply an upward force to the movable element (3).

14. The power generation device according to claim 12, further comprising :
at least one of a first stopper (71) and a second stopper (72) disposed lower than the first stopper (71), wherein
the movable element (3) is configured such that, when moved downward from the first position, the first stopper (71) allows the first power generation element (1) to separate from the movable element (3) before the movable element (3) contacts the second power generation element (2), and
the movable element (3) is configured such that, when moved upward from the second position, the second stopper (72) allows the second power generation element (2) to separate from the movable element before the movable element (3) contacts the first power generation element (1).

## Patentansprüche

1. Eingabevorrichtung, die Folgendes umfasst:
eine Energieerzeugungsvorrichtung (10, 10A-10C), die Folgendes umfasst:
ein erstes piezoelektrisches vibrierendes Energieerzeugungselement (1), das dazu ausgelegt ist zu vibrieren, um elektrische Energie zu erzeugen;
ein zweites piezoelektrisches vibrierendes Energieerzeugungselement (2), das niedriger als das erste Energieerzeugungselement (1) liegt und dazu ausgelegt ist zu vibrieren, um elektrische Energie zu erzeugen; und
ein bewegbares Element (3), das aus einem magnetischen Material gebildet und dazu ausgelegt ist, das erste Energieerzeugungselement (1) nach unten anzuziehen, wenn sich das bewegbare Element (3) nach unten bewegt, und das zweite Energieerzeugungselement (2) nach oben zu bewegen, wenn sich das bewegbare Element (3) nach oben bewegt, wobei
das erste Energieerzeugungselement (1) dazu ausgelegt ist, infolge der Abwärtsbewegung des bewegbaren Elements (3) zu vibrieren, und
das zweite Energieerzeugungselement (2) infolge der Aufwärtsbewegung des bewegbaren Elements (3) vibriert,
**dadurch gekennzeichnet, dass**
eine Steuerschaltung (204, 209) dazu ausgelegt ist, unter Verwendung der elektrischen Energie, die von der Energieerzeugungsvorrichtung (10, 10A-10C) erzeugt wird, betrieben zu werden; und dadurch, dass
eine Bestimmungsschaltung (205) dazu ausgelegt ist, wenn die elektrische Energie an der Energieerzeugungsvorrichtung (10, 10A-10C) erzeugt wird, zu bestimmen, an welchem des ersten Energieerzeugungselements (1) und des zweiten Energieerzeugungselements (2) die elektrische Energie erzeugt wurde.

2. Eingabevorrichtung nach Anspruch 1, die ferner Folgendes umfasst:
eine erste Gleichrichterschaltung (201), die dazu ausgelegt ist, einen elektrischen Strom, der vom ersten Energieerzeugungselement (1) geliefert wird, anzupassen, um den elektrischen Strom zu veranlassen, in eine Richtung zu fließen; und
eine zweite Gleichrichterschaltung (202), die dazu ausgelegt ist, einen elektrischen Strom, der vom zweiten Energieerzeugungselement (2) geliefert wird, anzupassen, um den elektrischen Strom zu veranlassen, in eine Richtung zu fließen; wobei
die Bestimmungsschaltung (205) einen ersten Eingabeanschluss (2051) beinhaltet, der mit der ersten Gleichrichterschaltung (201) verbunden ist, und einen zweiten Eingabeanschluss (2052), der mit der zweiten Gleichrichterschaltung (202) verbunden ist.

3. Eingabevorrichtung nach Anspruch 1 oder 2, die ferner Folgendes umfasst:
einen Fehlfunktionsverhinderer, wobei
der Fehlfunktionsverhinderer dazu ausgelegt ist, die Eingabevorrichtung derart einzuschränken, dass in einer spezifischen Situation keine vorbestimmte Operation durchgeführt wird, und
die spezifische Situation ein Zustand ist, in dem das bewegbare Element (3) nicht unter einer externen Druckkraft steht und die elektrische Energie an der Energieerzeugungsvorrichtung (10, 10A-10C) erzeugt wird.

4. Eingabevorrichtung nach Anspruch 1, die ferner Folgendes umfasst:
einen Stützkörper (4, 4A), der aus einem magnetischen Material gebildet ist, wobei
der Stützkörper (4, 4A) einen Hauptkörperabschnitt (41) und einen gemeinsam verwendeten magnetischen Pfadabschnitt (42) beinhaltet, der sich vom Hauptkörperabschnitt (41) erstreckt,
jedes von einem Ende des ersten Energieerzeugungselements (1), einem Ende des gemeinsam verwendeten magnetischen Pfadabschnitts (42) und einem Ende des zweiten Energieerzeugungselements (2) mit dem Hauptkörperabschnitt (41) verbunden ist,
das erste Energieerzeugungselement (1), der gemeinsam verwendete magnetische Pfadabschnitt (42) und das zweite Energieerzeugungselement (2) von oben nach unten in der folgenden Reihenfolge beabstandet und angeordnet sind: das erste Energieerzeugungselement (1); der gemeinsam verwendete magnetische Pfadabschnitt (42); und das zweite Energieerzeugungselement (2),
wenn sich das bewegbare Element (3) in der ersten Position befindet, das erste Energieerzeugungselement (1), der gemeinsam verwendete magnetische Pfadabschnitt (42), der Hauptkörperabschnitt (41) und das bewegbare Element (3) einen ersten geschlossenen magnetischen Pfad bilden, und
das bewegbare Element (3) derart ausgelegt ist, dass, wenn es sich in der zweiten Position befindet, das zweite Energieerzeugungselement (2), der gemeinsam verwendete magnetische Pfadabschnitt (42), der Hauptkörperabschnitt (41) und das bewegbare Element (3) einen zweiten geschlossenen magnetischen Pfad bilden, und
eine Spule (8) auf einem magnetischen Pfad, der den Stützkörper (4, 4A), das erste Energieerzeugungselement (1) und das zweite Energieerzeugungselement (2) beinhaltet, oder die Spule (8) ist um den gemeinsam verwendeten magnetischen Pfadabschnitt (42) des Stützkörpers (4, 4A) gewickelt,
wobei
die Bestimmungsschaltung (205) dazu ausgelegt ist, auf Basis einer Richtung eines elektrischen Stroms, der an der Spule (8) erzeugt wird, zu bestimmen, an welchem des ersten Energieerzeugungselements (1) und des zweiten Energieerzeugungselements (2) die elektrische Energie erzeugt wurde.

5. Eingabevorrichtung nach Anspruch 4, wobei
die Steuerschaltung (204, 209) eine Fehlfunktionsverhinderungsschaltung beinhaltet, die mit der Spule (8) verbunden ist,
die Fehlfunktionsverhinderungsschaltung dazu ausgelegt ist, die Steuerschaltung (204, 209) derart einzuschränken, dass in einer spezifischen Situation keine vorbestimmte Operation durchgeführt wird,
die spezifische Situation ein Zustand ist, in dem das bewegbare Element (3) nicht unter einer externen Druckkraft steht und die elektrische Energie an der Energieerzeugungsvorrichtung (10, 10A-10C) erzeugt wird, und
die Fehlfunktionsverhinderungsschaltung derart ausgelegt ist, dass, wenn ihr der elektrische Strom von der Spule (8) zugeführt wird, die Fehlfunktionsverhinderungsschaltung es der Steuerschaltung (204, 209) erlaubt, die vorbestimmte Operation durchzuführen.

6. Eingabevorrichtung nach Anspruch 1, wobei
das bewegbare Element (3) sich zwischen einer ersten Position und einer zweiten Position, die niedriger als die erste Position liegt, bewegt,
wenn sich das bewegbare Element (3) in der ersten Position befindet, das bewegbare Element (3) mit dem ersten Energieerzeugungselement (1) in Kontakt und vom zweiten Energieerzeugungselement (2) getrennt ist, und
das bewegbare Element (3) derart ausgelegt ist, dass, wenn es sich in der zweiten Position befindet, das bewegbare Element (3) vom ersten Energieerzeugungselement (1) getrennt und mit dem zweiten Energieerzeugungselement (2) in Kontakt ist.

7. Eingabevorrichtung nach Anspruch 6, die ferner Folgendes umfasst:
einen Druckknopf (5), der dazu ausgelegt ist, wenn er gedrückt wird, das bewegbare Element (3) nach unten zu bewegen; und
einen Rücklaufabschnitt (6), der dazu ausgelegt ist, eine Aufwärtskraft auf das bewegbare Element (3) auszuüben.

8. Eingabevorrichtung nach Anspruch 6 oder 7, die ferner Folgendes umfasst:
mindestens einen ersten Anschlag (71) und einen zweiten Anschlag (72), der niedriger angebracht ist als der erste Anschlag (71), wobei
das bewegbare Element (3) derart ausgelegt ist, dass, wenn es von der ersten Position nach unten bewegt wird, der erste Anschlag (71) es dem ersten Energieerzeugungselement (1) erlaubt, sich vom bewegbaren Element (3) zu trennen, bevor das bewegbare Element (3) das zweite Energieerzeugungselement (2) kontaktiert, und
das bewegbare Element (3) derart ausgelegt ist, dass, wenn es von der zweiten Position nach oben bewegt wird, der zweite Anschlag (72) es dem zweiten Energieerzeugungselement (2) erlaubt, sich vom bewegbaren Element (3) zu trennen, bevor das bewegbare Element (3) das erste Energieerzeugungselement (1) kontaktiert.

9. Eingabevorrichtung nach einem der Ansprüche 6 bis 8, die ferner Folgendes umfasst:
einen Stützkörper (4, 4A), der aus einem magnetischen Material gebildet ist, wobei
der Stützkörper (4, 4A) einen Hauptkörperabschnitt (41) und einen gemeinsam verwendeten magnetischen Pfadabschnitt (42) beinhaltet, der sich vom Hauptkörperabschnitt (41) erstreckt,
jedes von einem Ende des ersten Energieerzeugungselements (1), einem Ende des gemeinsam verwendeten magnetischen Pfadabschnitts (42) und einem Ende des zweiten Energieerzeugungselements (2) mit dem Hauptkörperabschnitt (41) verbunden ist,
das erste Energieerzeugungselement (1), der gemeinsam verwendete magnetische Pfadabschnitt (42) und das zweite Energieerzeugungselement (2) von oben nach unten in der folgenden Reihenfolge beabstandet und angeordnet sind: das erste Energieerzeugungselement (1); der gemeinsam verwendete magnetische Pfadabschnitt (42); und das zweite Energieerzeugungselement (2),
das bewegbare Element (3) derart ausgelegt ist, dass, wenn es sich in der ersten Position befindet, das erste Energieerzeugungselement (1), der gemeinsam verwendete magnetische Pfadabschnitt (42), der Hauptkörperabschnitt (41) und das bewegbare Element (3) einen ersten geschlossenen magnetischen Pfad bilden, und
das bewegbare Element (3) derart ausgelegt ist, dass, wenn es sich in der zweiten Position befindet, das zweite Energieerzeugungselement (2), der gemeinsam verwendete magnetische Pfadabschnitt (42), der Hauptkörperabschnitt (41) und das bewegbare Element (3) einen zweiten geschlossenen magnetischen Pfad bilden.

10. Eingabevorrichtung nach Anspruch 9, die ferner Folgendes umfasst:
eine Spule (8) auf einem magnetischen Pfad, der den Stützkörper (4, 4A), das erste Energieerzeugungselement (1) und das zweite Energieerzeugungselement (2) beinhaltet.

11. Eingabevorrichtung nach Anspruch 10, wobei
die Spule (8) um den gemeinsam verwendeten magnetischen Pfadabschnitt (42) des Stützkörpers (4, 4A) gewickelt ist.

12. Energieerzeugungsvorrichtung, die Folgendes umfasst:
ein erstes piezoelektrisches vibrierendes Energieerzeugungselement (1), das dazu ausgelegt ist zu vibrieren, um elektrische Energie zu erzeugen;
ein zweites piezoelektrisches vibrierendes Energieerzeugungselement (2), das niedriger als das erste Energieerzeugungselement (1) liegt und dazu ausgelegt ist zu vibrieren, um elektrische Energie zu erzeugen; und
ein bewegbares Element (3), das dazu ausgelegt ist, das erste Energieerzeugungselement (1) nach unten anzuziehen, wenn sich das bewegbare Element (3) nach unten bewegt, und das zweite Energieerzeugungselement (2) nach oben zu bewegen, wenn sich das bewegbare Element (3) nach oben bewegt, wobei
das erste Energieerzeugungselement (1) dazu ausgelegt ist, infolge der Abwärtsbewegung des bewegbaren Elements (3) zu vibrieren, und
das zweite Energieerzeugungselement (2) dazu ausgelegt ist, infolge der Aufwärtsbewegung des bewegbaren Elements (3) zu vibrieren,
das bewegbare Element (3) dazu ausgelegt ist, sich zwischen einer ersten Position und einer zweiten Position, die niedriger als die erste Position liegt, zu bewegen,
das bewegbare Element (3) derart ausgelegt ist, dass, wenn es sich in der ersten Position befindet, das bewegbare Element (3) mit dem ersten Energieerzeugungselement (1) in Kontakt und vom zweiten Energieerzeugungselement (2) getrennt ist, und
das bewegbare Element (3) derart ausgelegt ist, dass, wenn es sich in der zweiten Position befindet, das bewegbare Element (3) vom ersten Energieerzeugungselement (1) getrennt und mit dem zweiten Energieerzeugungselement (2) in Kontakt ist,
einen Stützkörper (4, 4A), der aus einem magnetischen Material gebildet ist, wobei
der Stützkörper (4, 4A) beinhaltet: einen Hauptkörperabschnitt (41); und einen gemeinsam verwendeten magnetischen Pfadabschnitt (42), der sich vom Hauptkörperabschnitt (41) erstreckt,
jedes von einem Ende des ersten Energieerzeugungselements (1), einem Ende des gemeinsam verwendeten magnetischen Pfadabschnitts (42) und einem Ende des zweiten Energieerzeugungselements (2) mit dem Hauptkörperabschnitt (41) verbunden ist,
das erste Energieerzeugungselement (1), der gemeinsam verwendete magnetische Pfadabschnitt (42) und das zweite Energieerzeugungselement (2) von oben nach unten in der folgenden Reihenfolge beabstandet und angeordnet sind: das erste Energieerzeugungselement (1); der gemeinsam verwendete magnetische Pfadabschnitt (42); und das zweite Energieerzeugungselement (2),
eine Spule (8) um den gemeinsam verwendeten magnetischen Pfadabschnitt (42) des Stützkörpers (4, 4A) gewickelt ist
**dadurch gekennzeichnet, dass** das bewegbare Element (3) derart ausgelegt ist, dass, wenn es sich in der ersten Position befindet, das erste Energieerzeugungselement (1), der gemeinsam verwendete magnetische Pfadabschnitt (42), der Hauptkörperabschnitt (41) und das bewegbare Element (3) einen ersten geschlossenen magnetischen Pfad bilden,
dadurch, dass das bewegbare Element (3) derart ausgelegt ist, dass, wenn es sich in der zweiten Position befindet, das zweite Energieerzeugungselement (2), der gemeinsam verwendete magnetische Pfadabschnitt (42), der Hauptkörperabschnitt (41) und das bewegbare Element (3) einen zweiten geschlossenen magnetischen Pfad bilden, und dadurch, dass die Spule (8) sich auf einem magnetischen Pfad befindet, der den Stützkörper (4, 4A), das erste Energieerzeugungselement (1) und das zweite Energieerzeugungselement (2) beinhaltet.

13. Energieerzeugungsvorrichtung nach dem vorhergehenden Anspruch, die ferner Folgendes umfasst:
einen Druckknopf (5), der dazu ausgelegt ist, wenn er gedrückt wird, das bewegbare Element (3) nach unten zu bewegen; und
einen Rücklaufabschnitt (6), der dazu ausgelegt ist, eine Aufwärtskraft auf das bewegbare Element (3) auszuüben.

14. Energieerzeugungsvorrichtung nach Anspruch 12, die ferner Folgendes umfasst:
mindestens einen ersten Anschlag (71) und einen zweiten Anschlag (72), der niedriger angebracht ist als der erste Anschlag (71), wobei
das bewegbare Element (3) derart ausgelegt ist, dass, wenn es von der ersten Position nach unten bewegt wird, der erste Anschlag (71) es dem ersten Energieerzeugungselement (1) erlaubt, sich vom bewegbaren Element (3) zu trennen, bevor das bewegbare Element (3) das zweite Energieerzeugungselement (2) kontaktiert, und
das bewegbare Element (3) derart ausgelegt ist, dass, wenn es von der zweiten Position nach oben bewegt wird, der zweite Anschlag (72) es dem zweiten Energieerzeugungselement (2) erlaubt, sich vom bewegbaren Element zu trennen, bevor das bewegbare Element (3) das erste Energieerzeugungselement (1) kontaktiert.

## Revendications

1. Dispositif d'entrée comprenant :
un dispositif de génération de puissance (10, 10A-10C) comprenant :
un premier élément de génération de puissance (1) de vibration piézoélectrique configuré pour vibrer pour générer de la puissance électrique ;
un deuxième élément de génération de puissance (2) de vibration piézoélectrique situé plus bas que le premier élément de génération de puissance (1) et configuré pour vibrer pour générer de la puissance électrique ; et
un élément mobile (3) formé d'un matériau magnétique et configuré pour attirer le premier élément de génération de puissance (1) vers le bas lorsque l'élément mobile (3) se déplace vers le bas, et attirer le deuxième élément de génération de puissance (2) vers le haut lorsque l'élément mobile (3) se déplace vers le haut, dans lequel
le premier élément de génération de puissance (1) est configuré pour vibrer à la suite du déplacement vers le bas de l'élément mobile (3), et
le deuxième élément de génération de puissance (2) vibre à la suite du déplacement vers le haut de l'élément mobile (3),
**caractérisé en ce que**
un circuit de commande (204, 209) est configuré pour fonctionner en utilisant la puissance électrique générée au niveau du dispositif de génération de puissance (10, 10A-10C) ; et **en ce que**
un circuit de détermination (205) est configuré pour, lorsque la puissance électrique est générée au niveau du dispositif de génération de puissance (10, 10A-10C), déterminer celui parmi le premier élément de génération de puissance (1) et le deuxième élément de génération de puissance (2) au niveau duquel la puissance électrique a été générée.

2. Dispositif d'entrée selon la revendication 1, comprenant en outre :
un premier circuit redresseur (201) configuré pour régler un courant électrique fourni par le premier élément de génération de puissance (1) afin d'amener le courant électrique à circuler dans un sens ; et
un deuxième circuit redresseur (202) configuré pour régler un courant électrique fourni par le deuxième élément de génération de puissance (2) afin d'amener le courant électrique à circuler dans un sens, dans lequel
le circuit de détermination (205) comporte une première borne d'entrée (2051) connectée au premier circuit redresseur (201) et une deuxième borne d'entrée (2052) connectée au deuxième circuit redresseur (202).

3. Dispositif d'entrée selon la revendication 1 ou 2, comprenant en outre :
un dispositif de prévention des dysfonctionnements, dans lequel
le dispositif de prévention des dysfonctionnements est configuré pour empêcher le dispositif d'entrée de réaliser une opération prédéterminée dans une situation spécifique, et
la situation spécifique est un état dans lequel l'élément mobile (3) n'est pas soumis à une force de pression externe et où la puissance électrique est générée au niveau du dispositif de génération de puissance (10, 10A-10C).

4. Dispositif d'entrée selon la revendication 1, comprenant en outre :
un corps de support (4, 4A) formé d'un matériau magnétique, dans lequel le corps de support (4, 4A) comporte une partie de corps principal (41) et une partie de chemin magnétique partagé (42) s'étendant depuis la partie de corps principal (41),
chacune parmi une extrémité du premier élément de génération de puissance (1), une extrémité de la partie de chemin magnétique partagé (42) et une extrémité du deuxième élément de génération de puissance (2) est connectée à la partie de corps principal (41),
le premier élément de génération de puissance (1), la partie de chemin magnétique partagé (42) et le deuxième élément de génération de puissance (2) sont espacés et agencés dans l'ordre suivant de haut en bas : le premier élément de génération de puissance (1) ; la partie de chemin magnétique partagé (42) ; et le deuxième élément de génération de puissance (2),
lorsque l'élément mobile (3) est dans la première position, le premier élément de génération de puissance (1), la partie de chemin magnétique partagé (42), la partie de corps principal (41) et l'élément mobile (3) forment un premier chemin magnétique fermé, et
l'élément mobile (3) est configuré de telle sorte que lorsqu'il est dans la deuxième position, le deuxième élément de génération de puissance (2), la partie de chemin magnétique partagé (42), la partie de corps principal (41) et l'élément mobile (3) forment un deuxième chemin magnétique fermé, et
une bobine (8) sur un chemin magnétique comporte le corps de support (4, 4A), le premier élément de génération de puissance (1) et le deuxième élément de génération de puissance (2), ou la bobine (8) est enroulée autour de la partie de chemin magnétique partagé (42) du corps de support (4, 4A), dans lequel
le circuit de détermination (205) est configuré pour déterminer, sur la base du sens d'un courant électrique généré au niveau de la bobine (8), celui parmi le premier élément de génération de puissance (1) et le deuxième élément de génération de puissance (2) au niveau duquel la puissance électrique a été générée.

5. Dispositif d'entrée selon la revendication 4, dans lequel
le circuit de commande (204, 209) comporte un circuit de prévention des dysfonctionnements connecté à la bobine (8),
le circuit de prévention des dysfonctionnements est configuré pour empêcher le circuit de commande (204, 209) de réaliser une opération prédéterminée dans une situation spécifique,
la situation spécifique est un état dans lequel l'élément mobile (3) n'est pas soumis à une force de pression externe et où la puissance électrique est générée au niveau du dispositif de génération de puissance (10, 10A-10C), et
le circuit de prévention des dysfonctionnements est configuré de telle sorte que, lorsqu'il est alimenté en courant électrique par la bobine (8), le circuit de prévention des dysfonctionnements permet au circuit de commande (204, 209) de réaliser l'opération prédéterminée.

6. Dispositif d'entrée selon la revendication 1, dans lequel
l'élément mobile (3) se déplace entre une première position et une deuxième position située plus bas que la première position,
lorsque l'élément mobile (3) est dans la première position, l'élément mobile (3) est en contact avec le premier élément de génération de puissance (1) et séparé du deuxième élément de génération de puissance (2), et
l'élément mobile (3) est configuré de telle sorte que lorsqu'il est dans la deuxième position, l'élément mobile (3) est séparé du premier élément de génération de puissance (1) et est en contact avec le deuxième élément de génération de puissance (2).

7. Dispositif d'entrée selon la revendication 6, comprenant en outre :
un bouton poussoir (5) configuré pour, lorsqu'il est enfoncé, déplacer l'élément mobile (3) vers le bas ; et
une partie de rappel (6) configurée pour appliquer une force vers le haut à l'élément mobile (3).

8. Dispositif d'entrée selon la revendication 6 ou 7, comprenant en outre :
au moins une parmi une première butée (71) et une deuxième butée (72) disposée plus bas que la première butée (71), dans lequel
l'élément mobile (3) est configuré de telle sorte que lorsqu'il est déplacé vers le bas depuis la première position, la première butée (71) permet au premier élément de génération de puissance (1) de se séparer de l'élément mobile (3) avant que l'élément mobile (3) n'entre en contact avec le deuxième élément de génération de puissance (2), et
l'élément mobile (3) est configuré de telle sorte que lorsqu'il est déplacé vers le haut depuis la deuxième position, la deuxième butée (72) permet au deuxième élément de génération de puissance (2) de se séparer de l'élément mobile (3) avant que l'élément mobile (3) n'entre en contact avec le premier élément de génération de puissance (1).

9. Dispositif d'entrée selon l'une des revendications 6 à 8, comprenant en outre :
un corps de support (4, 4A) formé d'un matériau magnétique, dans lequel
le corps de support (4, 4A) comporte une partie de corps principal (41) et une partie de chemin magnétique partagé (42) s'étendant depuis la partie de corps principal (41),
chacune parmi une extrémité du premier élément de génération de puissance (1), une extrémité de la partie de chemin magnétique partagé (42) et une extrémité du deuxième élément de génération de puissance (2) est connectée à la partie de corps principal (41),
le premier élément de génération de puissance (1), la partie de chemin magnétique partagé (42) et le deuxième élément de génération de puissance (2) sont espacés et agencés dans l'ordre suivant de haut en bas : le premier élément de génération de puissance (1) ; la partie de chemin magnétique partagé (42) ; et le deuxième élément de génération de puissance (2),
l'élément mobile (3) est configuré de telle sorte que lorsqu'il est dans la première position, le premier élément de génération de puissance (1), la partie de chemin magnétique partagé (42), la partie de corps principal (41) et l'élément mobile (3) forment un premier chemin magnétique fermé, et
l'élément mobile (3) est configuré de telle sorte que lorsqu'il est dans la deuxième position, le deuxième élément de génération de puissance (2), la partie de chemin magnétique partagé (42), la partie de corps principal (41) et l'élément mobile (3) forment un deuxième chemin magnétique fermé.

10. Dispositif d'entrée selon la revendication 9, comprenant en outre :
une bobine (8) sur un chemin magnétique comporte le corps de support (4, 4A), le premier élément de génération de puissance (1) et le deuxième élément de génération de puissance (2).

11. Dispositif d'entrée selon la revendication 10, dans lequel
la bobine (8) est enroulée autour de la partie de chemin magnétique partagé (42) du corps de support (4, 4A).

12. Dispositif de génération de puissance comprenant :
un premier élément de génération de puissance (1) de vibration piézoélectrique configuré pour vibrer pour générer de la puissance électrique ;
un deuxième élément de génération de puissance (2) de vibration piézoélectrique situé plus bas que le premier élément de génération de puissance (1) et configuré pour vibrer pour générer de la puissance électrique ; et
un élément mobile (3) configuré pour attirer le premier élément de génération de puissance (1) vers le bas lorsque l'élément mobile (3) se déplace vers le bas, et attirer le deuxième élément de génération de puissance (2) vers le haut lorsque l'élément mobile (3) se déplace vers le haut, dans lequel
le premier élément de génération de puissance (1) est configuré pour vibrer à la suite du déplacement vers le bas de l'élément mobile (3), et
le deuxième élément de génération de puissance (2) est configuré pour vibrer à la suite du déplacement vers le haut de l'élément mobile (3),
l'élément mobile (3) est configuré pour se déplacer entre une première position et une deuxième position située plus bas que la première position,
l'élément mobile (3) est configuré de telle sorte que lorsqu'il est dans la première position, l'élément mobile (3) est en contact avec le premier élément de génération de puissance (1) et séparé du deuxième élément de génération de puissance (2), et
l'élément mobile (3) est configuré de telle sorte que lorsqu'il est dans la deuxième position, l'élément mobile (3) est séparé du premier élément de génération de puissance (1) et est en contact avec le deuxième élément de génération de puissance (2),
un corps de support (4, 4A) formé d'un matériau magnétique, dans lequel
le corps de support (4, 4A) comporte : une partie de corps principal (41) ; et une partie de chemin magnétique partagé (42) s'étendant depuis la partie de corps principal (41),
chacune parmi une extrémité du premier élément de génération de puissance (1), une extrémité de la partie de chemin magnétique partagé (42) et une extrémité du deuxième élément de génération de puissance (2) est connectée à la partie de corps principal (41),
le premier élément de génération de puissance (1), la partie de chemin magnétique partagé (42) et le deuxième élément de génération de puissance (2) sont espacés et agencés dans l'ordre suivant de haut en bas : le premier élément de génération de puissance (1) ; la partie de chemin magnétique partagé (42) ; et le deuxième élément de génération de puissance (2), une bobine (8) est enroulée autour de la partie de chemin magnétique partagé (42) du corps de support (4, 4A),
**caractérisé en ce que** l'élément mobile (3) est configuré de telle sorte que lorsqu'il est dans la première position, le premier élément de génération de puissance (1), la partie de chemin magnétique partagé (42), la partie de corps principal (41) et l'élément mobile (3) forment un premier chemin magnétique fermé,
**en ce que** l'élément mobile (3) est configuré de telle sorte que lorsqu'il est dans la deuxième position, le deuxième élément de génération de puissance (2), la partie de chemin magnétique partagé (42), la partie de corps principal (41) et l'élément mobile (3) forment un deuxième chemin magnétique fermé, et
**en ce que** la bobine (8) est située sur un chemin magnétique comportant le corps de support (4, 4A), le premier élément de génération de puissance (1) et le deuxième élément de génération de puissance (2).

13. Dispositif de génération de puissance selon la revendication précédente, comprenant en outre :
un bouton poussoir (5) configuré pour, lorsqu'il est enfoncé, déplacer l'élément mobile (3) vers le bas ; et
une partie de rappel (6) configurée pour appliquer une force vers le haut à l'élément mobile (3).

14. Dispositif de génération de puissance selon la revendication 12, comprenant en outre :
au moins une parmi une première butée (71) et une deuxième butée (72) disposée plus bas que la première butée (71), dans lequel
l'élément mobile (3) est configuré de telle sorte que lorsqu'il est déplacé vers le bas depuis la première position, la première butée (71) permet au premier élément de génération de puissance (1) de se séparer de l'élément mobile (3) avant que l'élément mobile (3) n'entre en contact avec le deuxième élément de génération de puissance (2), et
l'élément mobile (3) est configuré de telle sorte que lorsqu'il est déplacé vers le haut depuis la deuxième position, la deuxième butée (72) permet au deuxième élément de génération de puissance (2) de se séparer de l'élément mobile avant que l'élément mobile (3) n'entre en contact avec le premier élément de génération de puissance (1).
